# EUROPEAN PATENT APPLICATION

(11) **EP 4 579 746 A1**
(43) Date of publication of application: **02.07.2025**
(21) Application number: 24195361.1
(22) Date of filing: 20.08.2024
(51) Int. Cl.: H01L 25/075, H10H 29/01, H10H 29/851

(54) **DISPLAY DEVICE**

(30) Priority: 28.12.2023 KR 20230194741
(71) Applicant: LG Display Co., Ltd., Seoul 07336 (KR)
(72) Inventor: SHIN, Yuseop, 10845 Paju-si (KR); KWAK, YongSeok, 10845 Paju-si (KR)
(74) Representative: Ter Meer Steinmeister & Partner

(57) **Abstract**

The present disclosure relates to display devices. According to an embodiment of the present disclosure, the display device comprises a substrate on which a plurality of subpixels is defined, a plurality of light-emitting elements at least one of which is disposed in a corresponding subpixel of the plurality of subpixels on the substrate, and a plurality of color conversion blocks disposed on at least one light-emitting element among the plurality of light-emitting elements and configured to convert a wavelength of light emitted from the light-emitting element, wherein the plurality of color conversion blocks comprise: a plurality of color conversion particles, a plurality of magnetic particles, and a dielectric material configured to surround the plurality of color conversion particles and the plurality of magnetic particles. Therefore, it is possible to enhance the light emitting efficiency and the color uniformity for each subpixel.

## Description

This application claims the priority of Korean Patent Application No. 10-2023-0194741 filed on December 28, 2023, in the Korean Intellectual Property Office.

### Field

The present disclosure relates to a display device, and more particularly, to a display device including a color conversion block.

### Background

As display devices used for a monitor of a computer, a TV set, a mobile phone, and the like, there are an organic light-emitting display (OLED) configured to autonomously emit, and a liquid crystal display (LCD) that requires a separate light source.

The range of application of the display devices is diversified from the monitor of the computer and the TV set to personal mobile devices, and studies are being conducted on the display devices having wide display areas and having reduced volumes and weights.

In addition, recently, a display device including a light-emitting diode (LED) has attracted attention as a next-generation display device. Because the LED is made of an inorganic material instead of an organic material, the LED is more reliable and has a longer lifespan than a liquid crystal display device or an organic light-emitting display device. In addition, the LED may be quickly turned on or off, have excellent luminous efficiency, high impact resistance, and great stability, and display high-brightness images.

### SUMMARY

An object to be achieved by the present disclosure is to provide a display device including a color conversion block including a dielectric material such that the color conversion block may be self-assembled.

Another object to be achieved by the present disclosure is to provide a display device capable of operating with low power consumption by virtue of improved color conversion efficiency.

Still another object to be achieved by the present disclosure is to provide a display device with improved color uniformity for each subpixel.

Technical problems of the present invention are not limited to the aforementioned technical problems, and other technical problems, which are not mentioned above, may be clearly understood by those skilled in the art from the following descriptions. Other detailed matters of the exemplary embodiments are included in the detailed description and the drawings.

At least one of these objects are solved by the features of the independent claims.

According to an embodiment of the present disclosure, the display device comprises a substrate on which a plurality of subpixels is defined, a plurality of light-emitting elements at least one of which is disposed in a corresponding subpixel of the plurality of subpixels on the substrate, and a plurality of color conversion blocks disposed on at least one light-emitting element among the plurality of light-emitting elements and configured to convert a wavelength of light emitted from the light-emitting element, wherein the plurality of color conversion blocks comprise: a plurality of color conversion particles, a plurality of magnetic particles, and a dielectric material configured to surround the plurality of color conversion particles and the plurality of magnetic particles. Therefore, it is possible to enhance the light emitting efficiency and the color uniformity for each subpixel.

According to another embodiment of the present disclosure, the display device comprises a substrate; a plurality of light-emitting elements, emitting light of the same color, disposed on the substrate, the plurality of light-emitting elements corresponding to a plurality of subpixels and comprising a first light-emitting element and a second light-emitting element; a color conversion block disposed on the first light-emitting element and configured to convert a wavelength of light emitted from the first light-emitting element; and an assembling block disposed on the second light-emitting element and configured to transmit light emitted from the second light-emitting element without undergoing wavelength conversion; wherein the color conversion block comprises: a plurality of color conversion particles; a plurality of magnetic particles; and a dielectric material configured to surround the plurality of color conversion particles and the plurality of magnetic particles.

According to the present disclosure, the color conversion block includes the plurality of magnetic particles and the dielectric material, such that the color conversion block may be self-assembled, which may shorten the manufacturing process time.

According to the present disclosure, the color conversion block including the plurality of color conversion particles is formed, which may improve the color conversion efficiency and allow the display device to operate with low power consumption.

According to the present disclosure, it is possible to improve the color uniformity for each subpixel.

The effects according to the present disclosure are not limited to the above-mentioned effects, and more various effects are included in the present disclosure.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a schematic configuration view of a display device according to an embodiment of the present disclosure;
FIG. 2A is a partial cross-sectional view of the display device according to the embodiment of the present disclosure;
FIG. 2B is a perspective view of a tiling display device according to the embodiment of the present disclosure;
FIG. 3 is a schematic enlarged top plan view of a display area of the display device according to the embodiment of the present disclosure;
FIG. 4 is a cross-sectional view of one pixel in the display device according to the embodiment of the present disclosure;
FIG. 5 is a cross-sectional view of one pixel in a display device according to another embodiment of the present disclosure;
FIG. 6 is a cross-sectional view of one pixel in a display device according to another embodiment of the present disclosure;
FIG. 7 is a cross-sectional view of one pixel in a display device according to another embodiment of the present disclosure;
FIG. 8 is a cross-sectional view of one pixel in a display device according to another embodiment of the present disclosure;
FIG. 9 is a cross-sectional view of one pixel in a display device according to another embodiment of the present disclosure;
FIG. 10 is a cross-sectional view of one pixel in a display device according to another embodiment of the present disclosure;
FIG. 11 is a cross-sectional view of one pixel in a display device according to another embodiment of the present disclosure;
FIG. 12 is a cross-sectional view of one pixel in a display device according to another embodiment of the present disclosure;
FIG. 13 is a cross-sectional view of one pixel in a display device according to another embodiment of the present disclosure;
FIG. 14 is a cross-sectional view of one pixel in a display device according to another embodiment of the present disclosure;
FIG. 15 is a cross-sectional view of one pixel in a display device according to another embodiment of the present disclosure;
FIG. 16 is a cross-sectional view of one pixel in a display device according to another embodiment of the present disclosure; and
FIG. 17 is a cross-sectional view of one pixel in a display device according to another embodiment of the present disclosure.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of' used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a display device according to exemplary embodiments of the present disclosure will be described in detail with reference to accompanying drawings.

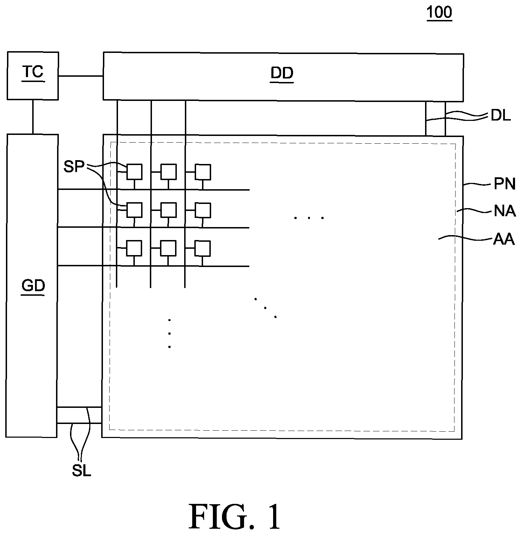

FIG. 1 is a schematic configuration view of a display device according to an embodiment of the present disclosure.

For convenience of description, FIG. 1 illustrates only a display panel PN, a gate drive part GD, a data drive part DD, and a timing controller TC among various constituent elements of a display device 100.

With reference to FIG. 1, the display device 100 may include the display panel PN including a plurality of subpixels SP, the gate drive part GD configured to supply various types of signals to the display panel PN, and the timing controller TC configured to control the data drive part DD, the gate drive part GD, and the data drive part DD.

The gate drive part GD supplies a plurality of scan signals to a plurality of scan lines SL in response to a plurality of gate control signals provided from the timing controller TC. FIG. 1 illustrates that the single gate drive part GD is disposed to be spaced apart from one side of the display panel PN. However, the number and arrangement of the gate drive part GD are not limited thereto.

The data drive part DD converts image data, which are inputted from the timing controller TC, into a data voltage by using a reference gamma voltage in response to a plurality of data control signals provided from the timing controller TC. The data drive part DD may supply the converted data voltage to a plurality of data lines DL.

The timing controller TC aligns image data, which are inputted from the outside, and supplies the image data to the data drive part DD. The timing controller TC may generate the gate control signals and the data control signals by using synchronizing signals, i.e., dot clock signals, data enable signals, and horizontal/vertical synchronizing signals inputted from the outside. Further, the timing controller TC may control the gate drive part GD and the data drive part DD by supplying the generated gate control signals and data control signals to the gate drive part GD and the data drive part DD.

The display panel PN is configured to display images to a user and may include the plurality of subpixels SP. In the display panel PN, the plurality of scan lines SL and the plurality of data lines DL may intersect one another, and each of the plurality of subpixels SP may be connected to the scan line SL and the data line DL. In addition, the plurality of subpixels SP may be respectively connected to a high-potential power line, a low-potential power line, a reference line, and the like.

The display panel PN may have a display area AA, and a non-display area NA configured to surround the display area AA.

The display area AA is an area of the display device 100 in which images are displayed. The display area AA may include the plurality of subpixels SP constituting a plurality of pixels PX, and a circuit configured to operate the plurality of subpixels SP. The plurality of subpixels SP is minimum units that constitute the display area AA. The n subpixels SP may constitute a single pixel PX. A light-emitting element 120, a thin-film transistor for operating the light-emitting element 120, and the like may be disposed in each of the plurality of subpixels SP. The plurality of light emitting elements 120 may be differently defined depending on the type of display panel PN. For example, in case that the display panel PN is an inorganic light-emitting display panel PN, the light-emitting element 120 may be a light-emitting diode (LED) or a micro light-emitting diode (micro LED).

A plurality of signal lines for transmitting various types of signals to the plurality of subpixels SP may be disposed in the display area AA. For example, the plurality of signal lines may include the plurality of data lines DL for supplying data voltages to the plurality of subpixels SP, and the plurality of scan lines SL for supplying gate voltages to the plurality of subpixels SP. The plurality of scan lines SL may extend in one direction in the display area AA and be connected to the plurality of subpixels SP. The plurality of data lines DL may extend in a direction different from one direction in the display area AA and be connected to the plurality of subpixels SP. In addition, a low-potential power line, a high-potential power line, and the like may be further disposed in the display area AA. However, the present disclosure is not limited thereto.

The non-display area NA may be defined as an area in which no image is displayed, i.e., an area extending from the display area AA. The non-display area NA may include link lines and pad electrodes for transmitting signals to the subpixels SP in the display area AA. Alternatively, the non-display area NA may include drive ICs such as gate drivers IC and data drivers IC.

Meanwhile, the non-display area NA may be positioned on a rear surface of the display panel PN, i.e., a surface on which the subpixel SP is not present. Alternatively, the non-display area NA may be excluded. However, the present disclosure is not limited to the configuration illustrated in the drawings.

Meanwhile, the drive parts such as the gate drive part GD, the data drive part DD, and the timing controller TC may be connected to the display panel PN in various ways. For example, the gate drive part GD may be mounted in the non-display area NA by a gate-in-panel (GIP) method or mounted between the plurality of subpixels SP by a gate-in-active area (GIA) method in the display area AA. For example, the data drive part DD and the timing controller TC may be formed on a separate flexible film and a printed circuit board (not illustrated) and electrically connected to the display panel PN by a method of bonding the flexible film and the printed circuit board to a pad electrode formed in the non-display area NA of the display panel PN. In case that the gate drive part GD is mounted by the GIP method and the data drive part DD and the timing controller TC transmit signals to the display panel PN through the pad electrode in the non-display area NA, it is necessary to ensure an area of the non-display area NA in order to dispose the gate drive part GD and the pad electrode, which may increase a bezel.

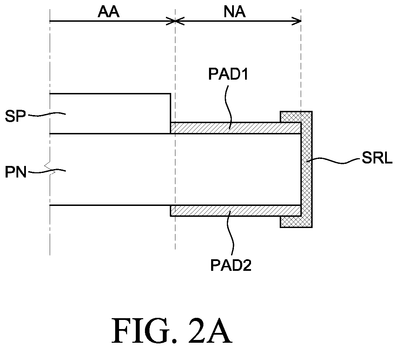

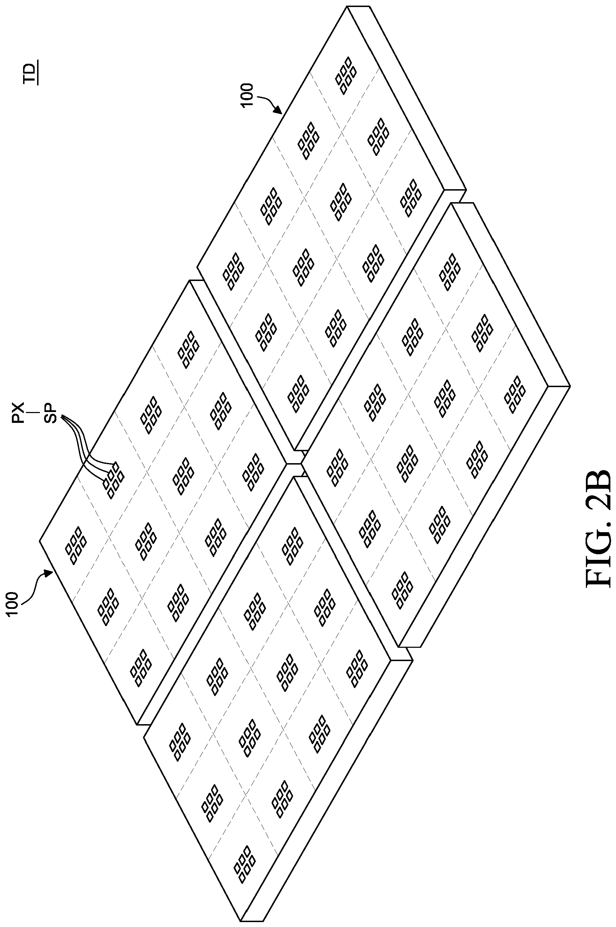

Alternatively, in case that the gate drive part GD is mounted in the display area AA by the GIA method and a side line SRL, which connects a signal line on a front surface of the display panel PN to the pad electrode on the rear surface of the display panel PN, is formed to bond the flexible film and the printed circuit board (not illustrated) to the rear surface of the display panel PN, it is possible to minimize the non-display area NA on the front surface of the display panel PN. That is, in case that the gate drive part GD, the data drive part DD, and the timing controller TC are connected to the display panel PN by the above-mentioned method, a zero bezel in which the bezel is not substantially present may be implemented. A more detailed description will be described with reference to FIGS. 2A and 2B.

FIG. 2A is a partial cross-sectional view of the display device according to the embodiment of the present disclosure. FIG. 2B is a perspective view of a tiling display device according to the embodiment of the present disclosure.

A plurality of pad electrodes for transmitting various types of signals to the plurality of subpixels SP may be disposed in the non-display area NA of the display panel PN. For example, a first pad electrode PAD1 configured to transmit signals to the plurality of subpixels SP may be disposed in the non-display area NA on the front surface of the display panel PN. A second pad electrode PAD2 electrically connected to drive components such as the flexible film and the printed circuit board (not illustrated) may be disposed in the non-display area NA on the rear surface of the display panel PN.

In this case, various types of signal lines, e.g., the scan line SL, the data line DL, or the like connected to the plurality of subpixels SP may extend from the display area AA to the non-display area NA and be electrically connected to the first pad electrode PAD1.

Further, the side line SRL may be disposed along a side surface of the display panel PN. The side line SRL may electrically connect the first pad electrode PAD1 on the front surface of the display panel PN and the second pad electrode PAD2 on the rear surface of the display panel PN. Therefore, the signals received from the drive components on the rear surface of the display panel PN may be transmitted to the plurality of subpixels SP through the second pad electrode PAD2, the side line SRL, and the first pad electrode PAD 1. Therefore, a signal transmission route is defined from the front surface to the side surface and the rear surface of the display panel PN, which may minimize an area of the non-display area NA of the display panel PN.

Further, with reference to FIG. 2B, a tiling display device TD having a large screen may be implemented by connecting a plurality of display devices 100. In this case, as illustrated in FIG. 2A, in case that the tiling display device TD is implemented by using the display device 100 with the minimized bezel, a seam area in which no image is displayed between the display devices 100 may be minimized, thereby improving display quality.

For example, the plurality of subpixels SP may constitute a single pixel PX. An interval D1 between an outermost peripheral pixel PX of one display device 100 and an outermost peripheral pixel PX of another display device 100 adjacent to one display device 100 may be implemented to be equal to the interval D1 between the pixels PX in one display device 100. Therefore, the seam area may be minimized as a constant interval of the pixels PX is implemented between the display device 100 and the display device 100.

However, as illustrated in FIG. 2A and FIG. 2B, the display device 100 according to the embodiment of the present disclosure may be a general display device in which the bezel is present. However, the present disclosure is not limited thereto.

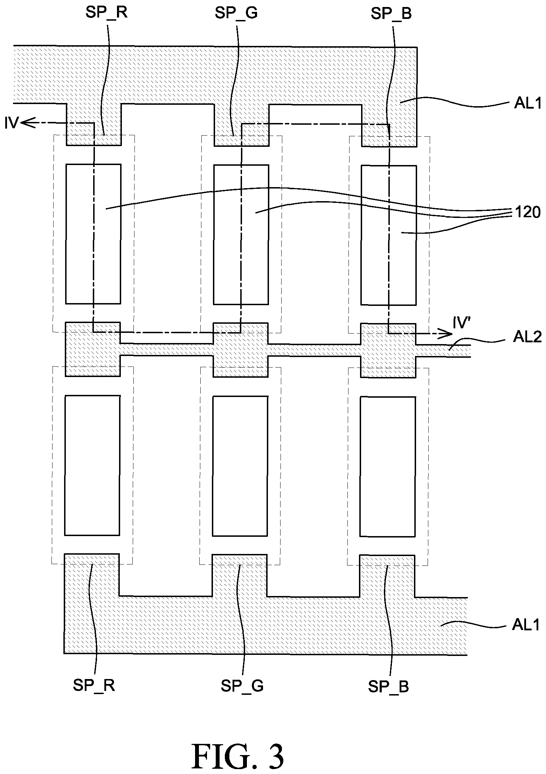

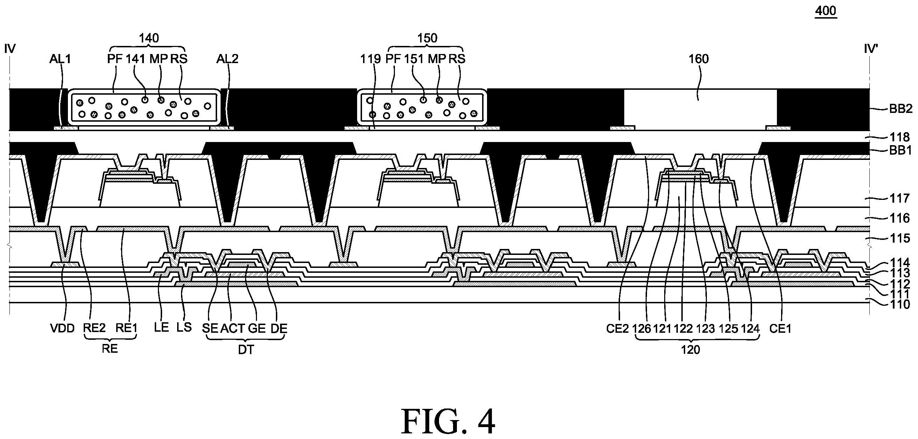

FIG. 3 is a schematic enlarged top plan view of a display area of the display device according to the embodiment of the present disclosure. FIG. 4 is a cross-sectional view of the pixel of the display device according to the embodiment of the present disclosure.

First, with reference to FIG. 3, the display panel PN includes the plurality of pixels PX each having the plurality of subpixels SP. The plurality of subpixels SP may each include the light-emitting element 120 and the pixel circuit and independently emit light. For example, the plurality of subpixels SP may include a red subpixel SP_R, a green subpixel SP_G, and a blue subpixel SP_B. However, the present disclosure is not limited thereto.

With reference to FIG. 4, the display device 100 according to the embodiment of the present disclosure may include a substrate 110, a buffer layer 111, a gate insulation layer 112, a first interlayer insulation layer 113, a second interlayer insulation layer 114, a first planarization layer 115, a first bonding layer 116, a second planarization layer 117, a third planarization layer 118, a second bonding layer 119, color conversion blocks 140 and 150, an organic layer 160, assembling lines AL1 and AL2, black banks BB1 and BB2, a driving transistor DT, a power line VDD, the light-emitting element 120, a reflective electrode RE, a first connection electrode CE1, a second connection electrode CE2, a light-blocking layer LS, and an auxiliary electrode LE.

First, the substrate 110 is a component for supporting various constituent elements included in the display device 100 and may be made of an insulating material. For example, the substrate 110 may be made of glass, resin, or the like. In addition, the substrate 110 may include plastic such as polymer and may be made of a material having flexibility.

The light-blocking layer LS may be disposed on each of the plurality of subpixels SP on the substrate 110. The light-blocking layer LS blocks light entering an active layer ACT of the driving transistor DT, which will be described below, from a lower side of the substrate 110. The light-blocking layer LS may block light entering the active layer ACT of the driving transistor DT, thereby minimizing a leakage current.

The buffer layer 111 may be disposed on the substrate 110 and the light-blocking layer LS. The buffer layer 111 may reduce the penetration of moisture or impurities through the substrate 110. For example, the buffer layer 111 may be configured as a single layer or multilayer made of silicon oxide (SiOx) or silicon nitride (SiNx). However, the present disclosure is not limited thereto. However, the buffer layer 111 may be excluded in accordance with the type of substrate 110 or the type of transistor. However, the present disclosure is not limited thereto.

The driving transistor DT may be disposed on the buffer layer 111. The driving transistor DT may include the active layer ACT, a gate electrode GE, a source electrode SE, and a drain electrode DE.

The active layer ACT may be disposed on the buffer layer 111. The active layer ACT may be made of a semiconductor material such as an oxide semiconductor, amorphous silicon, or polysilicon. However, the present disclosure is not limited thereto.

The gate insulation layer 112 may be disposed on the active layer ACT. The gate insulation layer 112 is an insulation layer for insulating the active layer ACT and the gate electrode GE. The gate insulation layer 112 may be configured as a single layer or multilayer made of silicon oxide (SiOx) or silicon nitride (SiNx). However, the present disclosure is not limited thereto.

The gate electrode GE may be disposed on the gate insulation layer 112. The gate electrode GE may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The first interlayer insulation layer 113 and the second interlayer insulation layer 114 may be disposed on the gate electrode GE. Contact holes, through which the source electrode SE and the drain electrode DE are connected to the active layer ACT, may be formed in the first interlayer insulation layer 113 and the second interlayer insulation layer 114. The first interlayer insulation layer 113 and the second interlayer insulation layer 114 may be insulation layers for protecting components disposed below the first interlayer insulation layer 113 and components disposed below the second interlayer insulation layer 114 and each configured as a single layer or multilayer made of silicon oxide (SiOx) or silicon nitride (SiNx). However, the present disclosure is not limited thereto.

The source electrode SE and the drain electrode DE, which are electrically connected to the active layer ACT, may be disposed on the second interlayer insulation layer 114. The source electrode SE and the drain electrode DE may each be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

Meanwhile, in the present disclosure, the configuration has been described in which the first interlayer insulation layer 113 and the second interlayer insulation layer 114, i.e., the plurality of insulation layers is disposed between the gate electrode GE, the source electrode SE, and the drain electrode DE. However, only a single insulation layer may be disposed between the gate electrode GE, the source electrode SE, and the drain electrode DE. However, the present disclosure is not limited thereto.

Further, as illustrated in the drawings, in case that the plurality of insulation layers, such as the first interlayer insulation layer 113 and the second interlayer insulation layer 114, is disposed between the gate electrode GE, the source electrode SE, and the drain electrode DE, an electrode may be additionally formed between the first interlayer insulation layer 113 and the second interlayer insulation layer 114. The additionally formed electrode may define a capacitor together with other components disposed on the lower portion of the first interlayer insulation layer 113 or the upper portion of the second interlayer insulation layer 114.

The auxiliary electrode LE may be disposed on the gate insulation layer 112. The auxiliary electrode LE is an electrode that electrically connects the light-blocking layer LS, disposed below the buffer layer 111, to any one of the source electrode SE and the drain electrode DE on the second interlayer insulation layer 114. For example, the light-blocking layer LS may be electrically connected to any one of the source electrode SE or the drain electrode DE through the auxiliary electrode LE so as not to be operated as a floating gate, thereby minimizing a change in threshold voltage of the driving transistor DT caused by the floating light-blocking layer LS. The drawing illustrates that the light-blocking layer LS is connected to the source electrode SE. However, the light-blocking layer LS may be connected to the drain electrode DE. However, the present disclosure is not limited thereto.

The power line VDD may be disposed on the second interlayer insulation layer 114. The power line VDD may be electrically connected to the light-emitting element 120 together with the driving transistor DT and allow the light-emitting element 120 to emit light. The power line VDD may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The first planarization layer 115 may be disposed on the driving transistor DT and the power line VDD. The first planarization layer 115 may planarize the upper portion of the substrate 110 on which the driving transistor DT is disposed. The first planarization layer 115 may be configured as a single layer or multilayer and made of a photoresist or an acrylic-based organic material, for example. However, the present disclosure is not limited thereto.

The plurality of reflective electrodes RE, spaced apart from one another, may be disposed on the first planarization layer 115. The plurality of reflective electrodes RE may serve to electrically connect the light-emitting element 120 to the power line VDD and the driving transistor DT and serve as a reflective plate that reflects light, emitted from the light-emitting element 120, to an upper portion of the light-emitting element 120. The plurality of reflective electrodes RE may each be made of an electrically conductive material having excellent reflection performance and reflect the light, emitted from the light-emitting element 120, toward the upper portion of the light-emitting element 120.

The plurality of reflective electrodes RE may include a first reflective electrode RE1 and a second reflective electrode RE2. The first reflective electrode RE1 may electrically connect the driving transistor DT and the light-emitting element 120. The first reflective electrode RE1 may be connected to the source electrode SE or the drain electrode DE of the driving transistor DT through a contact hole formed in the first planarization layer 115. Further, the first reflective electrode RE1 may be electrically connected to a first electrode 124 and a first semiconductor layer 121 of the light-emitting element 120 through the first connection electrode CE1 to be described below.

The second reflective electrode RE2 may electrically connect the power line VDD and the light-emitting element 120. The second reflective electrode RE2 may be connected to the power line VDD through the contact hole, formed in the first planarization layer 115, and electrically connected to a second electrode 125 and a second semiconductor layer 123 of the light-emitting element 120 through the second connection electrode CE2 to be described below.

The first bonding layer 116 may be disposed on the first planarization layer 115 and the plurality of reflective electrodes RE.

The first bonding layer 116 may fix the plurality of light-emitting elements 120 to be described below. For example, the first bonding layer 116 may be made of any one material selected from adhesive polymer, epoxy resist, UV resin, a polyimide-based material, an acrylate-based material, a urethane-based material, and polydimethylsiloxane (PDMS). However, the present disclosure is not limited thereto.

The light-emitting element 120 may include the first semiconductor layer 121, a light-emitting layer 122, the second semiconductor layer 123, the first electrode 124, the second electrode 125, and an encapsulation film 126. In this case, the plurality of light-emitting elements 120 may be blue light-emitting elements configured to emit blue light. The light beams with various colors may be emitted to the outside of the display device 100 through a plurality of color conversion elements to be described below.

The first semiconductor layer 121 may be disposed on the first bonding layer 116, and the second semiconductor layer 123 may be disposed on the first semiconductor layer 121. The first semiconductor layer 121 and the second semiconductor layer 123 may each be a layer formed by doping a particular material with n-type and p-type impurities. For example, the first semiconductor layer 121 and the second semiconductor layer 123 may each be a layer formed by doping a material, such as gallium nitride (GaN), indium aluminum phosphide (InAlP), or gallium arsenic (GaAs) with n-type and p-type impurities. Further, the p-type impurity may be magnesium, zinc (Zn), beryllium (Be), or the like. The n-type impurity may be silicon (Si), germanium, tin (Sn), or the like. However, the present disclosure is not limited thereto.

The light-emitting layer 122 may be disposed between the first semiconductor layer 121 and the second semiconductor layer 123. The light-emitting layer 122 may emit light by receiving positive holes and electrons from the first semiconductor layer 121 and the second semiconductor layer 123. The light-emitting layer 122 may be configured as a single layer or a multi-quantum well (MQW) structure. For example, the light-emitting layer 122 may be made of indium gallium nitride (InGaN), gallium nitride (GaN), or the like. However, the present disclosure is not limited thereto.

The first electrode 124 may be disposed on the first semiconductor layer 121. The first electrode 124 is an electrode that electrically connects the driving transistor DT and the first semiconductor layer 121. The first electrode 124 may be disposed on a top surface of the first semiconductor layer 121 exposed from the light-emitting layer 122 and the second semiconductor layer 123. The first electrode 124 may be made of an electrically conductive material, for example, a transparent conductive material such as indium tin oxide (ITO) or indium zinc oxide (IZO) or an opaque conductive material such as titanium (Ti), gold (Au), silver (Ag), copper (Cu), or an alloy thereof. However, the present disclosure is not limited thereto.

The second electrode 125 may be disposed on the second semiconductor layer 123. The second electrode 125 may be disposed on a top surface of the second semiconductor layer 123. The second electrode 125 is an electrode for electrically connecting the power line VDD and the second semiconductor layer 123. The second electrode 125 may be made of an electrically conductive material, for example, a transparent conductive material such as indium tin oxide (ITO) or indium zinc oxide (IZO) or an opaque conductive material such as titanium (Ti), gold (Au), silver (Ag), copper (Cu), or an alloy thereof. However, the present disclosure is not limited thereto.

Next, the encapsulation film 126 may be disposed to surround the first semiconductor layer 121, the light-emitting layer 122, the second semiconductor layer 123, the first electrode 124, and the second electrode 125. The encapsulation film 126 may be made of an insulating material and protect the first semiconductor layer 121, the light-emitting layer 122, and the second semiconductor layer 123. Further, a contact hole, through which the first electrode 124 and the second electrode 125 are exposed, may be formed in the encapsulation film 126, such that the first connection electrode CE1, the second connection electrode CE2, the first electrode 124, and the second electrode 125 may be electrically connected.

Meanwhile, a part of a side surface of the first semiconductor layer 121 may be exposed from the encapsulation film 126. The light-emitting element 120 manufactured on a wafer may be separated from the wafer and transferred to the display panel PN. However, a part of the encapsulation film 126 may be torn during a process of separating the light-emitting element 120 from the wafer. For example, a part of the encapsulation film 126 adjacent to a lower edge of the first semiconductor layer 121 of the light-emitting element 120 may be torn during the process of separating the light-emitting element 120 from the wafer, such that a lower portion of the side surface of the first semiconductor layer 121 may be exposed to the outside. However, even though the lower portion of the light-emitting element 120 is exposed from the encapsulation film 126, the first connection electrode CE1 and the second connection electrode CE2 are formed after a second planarization layer 116, which covers the side surface of the first semiconductor layer 121, is formed, thereby reducing a short circuit defect.

The second planarization layer 117 may be disposed on the first bonding layer 116. The second planarization layer 117 may be disposed to surround side surfaces of the plurality of light-emitting elements 120 and disposed to cover at least some of top surfaces of the plurality of light-emitting elements 120. Therefore, the plurality of light-emitting elements 120 may be fixed and protected. The second planarization layer 117 may be configured as a single layer or multilayer and made of a photoresist or an acrylic-based organic material, for example. However, the present disclosure is not limited thereto.

The first connection electrode CE1 and the second connection electrode CE2 may be disposed on the second planarization layer 117 and the light-emitting element 120.

The first connection electrode CE1 may be an electrode that electrically connects the light-emitting element 120 and the driving transistor DT. The first connection electrode CE1 may be connected to the first reflective electrode RE1 through contact holes formed in the second planarization layer 117 and the bonding layer 116. Therefore, the first connection electrode CE1 may be electrically connected to any one of the source electrode SE and the drain electrode DE of the driving transistor DT through the first reflective electrode RE1. Further, the first connection electrode CE1 may be connected to the first electrode 124 of the light-emitting element 120 while covering the light-emitting element 120. Therefore, the first connection electrode CE1 may electrically connect the driving transistor DT and the first electrode 124 and the first semiconductor layer 121 of each of the plurality of light-emitting elements 120.

The second connection electrode CE2 may be an electrode that electrically connects the light-emitting element 120 and the power line VDD. The second connection electrode CE2 may be connected to the second reflective electrode RE2 through contact holes formed in the second planarization layer 117 and the bonding layer 116. Therefore, the second connection electrode CE2 may be electrically connected to the power line VDD through the second reflective electrode RE2. Further, the second connection electrode CE2 may be connected to the second electrode 125 of the light-emitting element 120 while covering the light-emitting element 120. Therefore, the second connection electrode CE2 may electrically connect the power line VDD and the second electrode 125 and the second semiconductor layer 123 of each of the plurality of light-emitting elements 120.

The first black bank BB1 may be disposed on the first connection electrode CE1 and the second connection electrode CE2. The first black bank BB1 may be disposed to be spaced apart from the light-emitting element 120 at a predetermined interval. For example, the first black bank BB1 may be spaced apart from the light-emitting element 120 at a predetermined interval and partially cover the first connection electrode CE1 and the second connection electrode CE2 formed in the contact holes of the first bonding layer 116 and the second planarization layer 117. The first black bank BB1 may be made of an opaque material, for example, black resin to reduce a color mixture between the plurality of subpixels SP. However, the present disclosure is not limited thereto.

The third planarization layer 118 may be disposed on the first connection electrode CE1, the second connection electrode CE2, the light-emitting element 120, and the first black bank BB1. The third planarization layer 118 may cover the light-emitting element 120 to protect the light-emitting element 120. The third planarization layer 118 may be configured as a single layer or multilayer and made of a photoresist or an acrylic-based organic material, for example. However, the present disclosure is not limited thereto.

The plurality of assembling lines AL1 and AL2 may be disposed at one side and the other side of at least one light-emitting element 120 on the third planarization layer 118 among the plurality of light-emitting elements 120. The plurality of assembling lines AL1 and AL2 may include a first assembling line AL1 and a second assembling line AL2. The plurality of assembling lines AL1 and AL2 may each be disposed along the subpixels SP_R, SP_G, and SP_B of each of the plurality of pixels PX. In addition, the first assembling line AL1 and the second assembling line AL2 may be respectively disposed at two opposite sides of one light-emitting element 120. For example, the first assembling line AL1 may be disposed at one side of at least one light-emitting element 120, and the second assembling line AL2 may be disposed at the other side of at least one light-emitting element 120. The plurality of assembling lines AL1 and AL2 may generate electric fields for aligning the plurality of color conversion blocks 140 and 150 to be described below during a process of manufacturing the display device 100.

The plurality of assembling lines AL1 and AL2 may each be made of an electrically conductive material, e.g., a material such as copper (CU), chromium (Cr), indium tin oxide (ITO), or indium zinc oxide (IZO). However, the present disclosure is not limited thereto.

The plurality of second black banks BB2 may be disposed on the third planarization layer 118. The plurality of second black banks BB2 may be disposed on the third planarization layer 118 and disposed between the plurality of subpixels SP_R, SP_G, and SP_B. Therefore, it is possible to reduce color mixtures between the plurality of subpixels SP_R, SP_G, and SP_B. The second black bank BB2 may be disposed to cover one end of each of the plurality of assembling lines AL1 and AL2.

The second black bank BB2 may be made of an opaque material, for example, black resin. However, the present disclosure is not limited thereto.

The second bonding layer 119 may be disposed on the third planarization layer 118 and disposed between the first assembling line AL1 and the second assembling line AL2. That is, the second bonding layer 119 may be disposed on the light-emitting element 120 so as to overlap the light-emitting element 120.

The second bonding layer 119 may fix the plurality of color conversion blocks 140 and 150, which will be described below, onto the third planarization layer 118. However, the present disclosure is not limited thereto. The second bonding layer 119 may be excluded.

For example, the second bonding layer 119 may be made of any one material selected from adhesive polymer, epoxy resist, UV resin, a polyimide-based material, an acrylate-based material, a urethane-based material, and polydimethylsiloxane (PDMS). However, the present disclosure is not limited thereto.

The plurality of color conversion blocks 140 and 150 may be disposed on the second bonding layer 119. The plurality of color conversion blocks 140 and 150 may be disposed on at least one light-emitting element 120 among the plurality of light-emitting elements 120 and convert a wavelength of light emitted from the light-emitting element 120.

The plurality of color conversion blocks 140 and 150 may each have a shape disposed on the third planarization layer 118 and surrounded by the second black bank BB2.

Therefore, the plurality of color conversion blocks 140 and 150 may be disposed on the third planarization layer 118 and partially surround the plurality of assembling lines AL1 and AL2. For example, two opposite sides of the plurality of color conversion blocks 140 and 150 may be disposed on and overlap one side of the first assembling line AL1 and one side of the second assembling line AL2.

The plurality of color conversion blocks 140 and 150 may include a first color conversion block 140 disposed in the red subpixel SP_R and configured to convert blue light into red light, and a second color conversion block 150 disposed in the green subpixel SP_G and configured to convert blue light into green light.

The plurality of color conversion blocks 140 and 150 may each include a plurality of color conversion particles 141 and 151, a plurality of magnetic particles MP, resin RS in which the plurality of color conversion particles 141 and 151 and the plurality of magnetic particles MP are dispersed, and a dielectric film PF made of a dielectric material and configured to surround the plurality of color conversion particles 141 and 151, the plurality of magnetic particles MP, and the resin RS.

First, the first color conversion block 140 is disposed in the red subpixel SP_R. The first color conversion block 140 may convert blue light, emitted from the light-emitting element 120 disposed in the red subpixel SP_R, into red light.

The first color conversion block 140 includes a plurality of first color conversion particles 141, the plurality of magnetic particles MP, the resin RS in which the plurality of first color conversion particles 141 and the plurality of magnetic particles MP are dispersed, and the dielectric film PF made of a dielectric material and configured to surround the plurality of first color conversion particles 141, the plurality of magnetic particles MP, and the resin RS.

The plurality of first color conversion particles 141 are particles for converting blue light, emitted from the light-emitting element 120, into red light. Therefore, the plurality of first color conversion particles 141 may be particles having photoluminescence functions. For example, the plurality of first color conversion particles 141 may include nano-phosphors, organic phosphors, or quantum dots. However, the present disclosure is not limited thereto.

The plurality of magnetic particles MP may be particles for moving the plurality of first color conversion blocks 140 to a peripheral area adjacent to the third planarization layer 118 by using magnetic fields during the process of manufacturing the display device 100. Therefore, the plurality of magnetic particles MP may include transition metal such as ferromagnetic particles, ferrimagnetic particles, iron (Fe), cobalt (Co), or nickel (Ni), an oxide including transition metal, and a metal compound including rare-earth atoms such as neodymium (Nd) or samarium (Sm). However, the present disclosure is not limited thereto. One first color conversion block 140 may include the plurality of magnetic particles MP provided as one type or include the plurality of magnetic particles MP provided as two or more different types.

The resin RS may be in a cured state. Therefore, the plurality of first color conversion particles 141 and the plurality of magnetic particles MP, which are dispersed in the resin RS, may also be fixed to the resin RS. For example, the resin RS may be acrylic-based resin or epoxy-based resin. However, the present disclosure is not limited thereto.

The dielectric material may be the dielectric film PF. The dielectric film PF surrounds the resin RS and the plurality of first color conversion particles 141 and the plurality of magnetic particles MP, which are dispersed in the resin RS, to constitute the first color conversion block 140. The dielectric film PF may be provided in the form of a thin film made of a dielectric material. For example, the dielectric material may include silicon oxide (SiO₂), silicon carbide (SiC), silicon nitride (SiN), or aluminum oxide (Al₂O₃). However, the present disclosure is not limited thereto.

As described above, the plurality of first color conversion blocks 140 each includes the dielectric film PF, such that the plurality of first color conversion blocks 140 may have polarities by being dielectrically polarized but the electric fields formed by the plurality of assembling lines AL1 and AL2. As described above, the plurality of first color conversion blocks 140, dielectrically polarized, may be fixed or moved in a particular direction by dielectrophoresis (DEP), i.e., the electric field. Therefore, the dielectrophoresis may be used to fix the plurality of first color conversion blocks 140 onto the third planarization layer 118 on which the plurality of assembling lines AL1 and AL2 is disposed in the red subpixel SP_R.

Next, the second color conversion block 150 is disposed in the green subpixel SP_G. The second color conversion block 150 may convert blue light, emitted from the light-emitting element 120 disposed in the green subpixel SP_G, into green light.

The second color conversion block 150 includes a plurality of second color conversion particles 151, the plurality of magnetic particles MP, the resin RS in which the plurality of second color conversion particles 151 and the plurality of magnetic particles MP are dispersed, and the dielectric film PF made of a dielectric material and configured to surround the plurality of second color conversion particles 151, the plurality of magnetic particles MP, and the resin RS.

The plurality of second color conversion particles 151 are particles for converting blue light, emitted from the light-emitting element 120, into green light. Therefore, the plurality of second color conversion particles 151 may be particles having photoluminescence functions. For example, the plurality of second color conversion particles 151 may include nano-phosphors, organic phosphors, or quantum dots. However, the present disclosure is not limited thereto.

The plurality of magnetic particles MP may be particles for moving the plurality of second color conversion blocks 150 to a peripheral area adjacent to the third planarization layer 118 by using magnetic fields during the process of manufacturing the display device 100. Therefore, the plurality of magnetic particles MP may include transition metal such as ferromagnetic particles, ferrimagnetic particles, iron (Fe), cobalt (Co), or nickel (Ni), an oxide including transition metal, and a metal compound including rare-earth atoms such as neodymium (Nd) or samarium (Sm). However, the present disclosure is not limited thereto. One second color conversion block 150 may include the plurality of magnetic particles MP provided as one type or include the plurality of magnetic particles MP provided as two or more different types. In addition, the first color conversion block 140 and the second color conversion block 150 may include the same magnetic particles MP or include different types of magnetic particles MP.

The resin RS may be in a cured state. Therefore, the plurality of second color conversion particles 151 and the plurality of magnetic particles MP, which are dispersed in the resin RS, may also be fixed to the resin RS. For example, the resin RS may be acrylic-based resin or epoxy-based resin. However, the present disclosure is not limited thereto. The first color conversion block 140 and the second color conversion block 150 may include the same type of resin RS or include different types of resin RS.

The dielectric material may be the dielectric film PF. The dielectric film PF surrounds the resin RS and the plurality of second color conversion particles 151 and the plurality of magnetic particles MP, which are dispersed in the resin RS, to constitute the second color conversion block 150. The dielectric film PF may be provided in the form of a thin film made of a dielectric material. For example, the dielectric material may include silicon oxide (SiO₂), silicon carbide (SiC), silicon nitride (SiN), or aluminum oxide (Al₂O₃). However, the present disclosure is not limited thereto. The first color conversion block 140 and the second color conversion block 150 may include the dielectric films PF made of the same type of dielectric material or include the dielectric films PF made of different types of dielectric materials.

As described above, the plurality of second color conversion blocks 150 each includes the dielectric film PF, such that the plurality of second color conversion blocks 150 may have polarities by being dielectrically polarized by the electric fields formed by the plurality of assembling lines AL1 and AL2. As described above, the plurality of second color conversion blocks 150, dielectrically polarized, may be fixed or moved in a particular direction by dielectrophoresis (DEP), i.e., the electric field. Therefore, the dielectrophoresis may be used to fix the plurality of second color conversion blocks 150 onto the third planarization layer 118 on which the plurality of assembling lines AL1 and AL2 is disposed in the green subpixel SP_G.

The first color conversion block 140 and the second color conversion block 150 may have different sizes or shapes. For example, the first color conversion block 140 and the second color conversion block 150 may be identical in shape and different in sizes, or the first color conversion block 140 and the second color conversion block 150 may be identical in size and different in shapes. In addition, the first color conversion block 140 and the second color conversion block 150 may be different in both sizes and shapes. Therefore, during the process of manufacturing the display device 100 according to the embodiment of the present disclosure, the first color conversion block 140 and the second color conversion block 150 may be accurately disposed only in desired subpixels SP_R and SP_G. For example, the first color conversion block 140 may be disposed only in the red subpixel SP_R, and the second color conversion block 150 may be disposed only in the green subpixel SP_G.

In addition, the organic layer 160 may be disposed in the blue subpixel SP_B. The organic layer 160 may be made of a transparent resin, such that blue light emitted from the light-emitting element 120 may be discharged upward in an intact manner.

In the case of an organic light-emitting display device, there is a problem in that an organic light-emitting element made of an organic material is very vulnerable to moisture or oxygen. Therefore, there is a limitation in reducing a size of a bezel area when an encapsulation part for the organic light-emitting element is disposed. As an alternative, an LED, which is made of an inorganic material instead of an organic material, may be used as a light-emitting element, such that images with excellent luminous efficiency and high brightness may be displayed. For example, a micro-LED may be used when a size of the LED is 100 µm or less. As described above, the display device using the small-sized LED may display images with excellent luminous efficiency and high brightness. The display device may include red, green, and blue subpixels, and one pixel may emit light beams with various colors by means of a combination of the plurality of subpixels. A combination of the plurality of pixels may display various images. The light-emitting element, which emits red, green, or blue light, may be disposed in each of the subpixels. However, when the plurality of blue light-emitting elements may be disposed in the red, green, and blue subpixels at once, the processes of arranging the red and green light-emitting elements in the subpixels in the related art may be excluded. As described above, in case that the plurality of blue light-emitting elements is equally disposed in the red and green subpixels to reduce the number of arrangement processes, a color conversion layer may be additionally provided to convert blue light, emitted from the blue light-emitting element, into red light or green light.

In general, in order to improve the color conversion efficiency implemented by the color conversion layer, it is important to adjust a density of color conversion materials in the color conversion layer. A process in the related art, which transfers the color conversion materials through an inkjet process, disperses the color conversion materials into a monomer and then transfers the color conversion materials. In this case, a degree of dispersion, i.e., a density of the color conversion materials may vary depending on a degree to which the monomer volatilizes after the injection. Therefore, a thickness of the color conversion layer formed immediately after the color conversion materials are transferred is different from a thickness of the color conversion layer remaining after a predetermined time elapses. Therefore, there occurs a problem in that a density of the color conversion materials immediately after the color conversion materials are transferred is different from a density of the color conversion materials remaining after a predetermined time elapses. In addition, because it is difficult to precisely adjust the degree to which the monomer volatilizes, there is a problem in that it is also difficult to precisely adjust a density of the color conversion materials.

In addition, as described above, color conversion particles with sizes at a sub-micron level are required to transfer the color conversion materials through the inkjet process. Therefore, an additional process of cutting the color conversion material to a size at a sub-micron level is required, which causes a problem in that a process time increases. In addition, there is a problem in that the color conversion material is lost and the efficiency deteriorates during the process of cutting the color conversion material into a size at a sub-micron level. Therefore, a method may be used to coat the plurality of color conversion particles with a dielectric material and self assemble the color conversion particles to each of the subpixels by using dielectrophoresis. However, in this case, it is difficult to adjust the number of color conversion particles to be self-assembled to each of the subpixels, which may cause a problem of deterioration in color uniformity for each pixel.

Therefore, in the display device 100 according to the embodiment of the present disclosure, the plurality of light-emitting elements 120, which emits blue light, are respectively disposed in the plurality of subpixels SP_R, SP_G, and SP_B, and the plurality of color conversion blocks 140 and 150, which converts a wavelength of light emitted from the light-emitting element 120, is disposed on at least one light-emitting element 120 among the plurality of light-emitting elements 120. In addition, the color conversion blocks 140 and 150 include the plurality of color conversion particles 141 and 151, the plurality of magnetic particles MP, and the dielectric films PF made of a dielectric material and configured to surround the plurality of color conversion particles 141 and 151 and the plurality of magnetic particles MP.

Therefore, in the display device 100 according to the embodiment of the present disclosure, the plurality of color conversion blocks 140 and 150, which has the dielectric films PF that surround the plurality of color conversion particles 141 and 151, may be used, which may precisely adjust densities of the color conversion particles 141 and 151 in the color conversion blocks 140 and 150. In addition, the plurality of color conversion blocks 140 and 150 may suppress the changes in the densities of the color conversion particles 141 and 151 during the manufacturing process. In the display device 100 according to the embodiment of the present disclosure, the plurality of color conversion blocks 140 and 150 may be formed as described above, such that the changes in the densities of the color conversion particles 141 and 151 may be suppressed, which may improve the color conversion efficiency and allow the display device to operate with low power consumption.

In addition, in the display device 100 according to the embodiment of the present disclosure, it is possible to precisely adjust the number of color conversion particles 141 and 151 respectively included in the plurality of color conversion blocks 140 and 150. Therefore, it is possible to improve the color uniformity between the subpixels SP_R, SP_G, and SP_B.

To this end, the display device 100 according to the embodiment of the present disclosure may further include the plurality of assembling lines AL1 and AL2.

As described above, the plurality of color conversion blocks 140 and 150 may each include the dielectric film PF, such that the self-assembling may be performed by the electric fields formed by the plurality of assembling lines AL1 and AL2.

For example, in case that the display device 100 according to the embodiment of the present disclosure includes the plurality of assembling lines AL1 and AL2 including the first assembling line AL1 and the second assembling line AL2, the electric fields may be formed by applying different voltages to the first assembling line AL1 and the second assembling line AL2 during the process of manufacturing the display device 100. Therefore, the plurality of color conversion blocks 140 and 150 may have polarities as the dielectric films PF are dielectrically polarized by the electric fields generated by the first assembling line AL1 and the second assembling line AL2. Further, the plurality of color conversion blocks 140 and 150, which is dielectrically polarized, may be fixed or moved in a particular direction by dielectrophoresis, i.e., the electric field. Therefore, in the display device 100 according to the embodiment of the present disclosure, the dielectrophoresis may be used to easily fix the plurality of color conversion blocks 140 and 150 onto the third planarization layer 118. As described above, in the display device 100 according to the embodiment of the present disclosure, the plurality of color conversion blocks 140 and 150 are self-assembled by using the dielectrophoresis during the manufacturing process, which may shorten the process time.

In addition, as described above, in the display device 100 according to the embodiment of the present disclosure, the plurality of color conversion blocks 140 and 150 may be formed and self-assembled during the manufacturing process, such that it is not necessary to reduce the sizes of the plurality of color conversion particles 141 and 151. Therefore, a separate process of splitting the plurality of color conversion particles 141 and 151 may be excluded, which may shorten the process time. Furthermore, it is possible to suppress a loss of the plurality of color conversion particles 141 and 151 that may be caused by the process of splitting the plurality of color conversion particles 141 and 151.

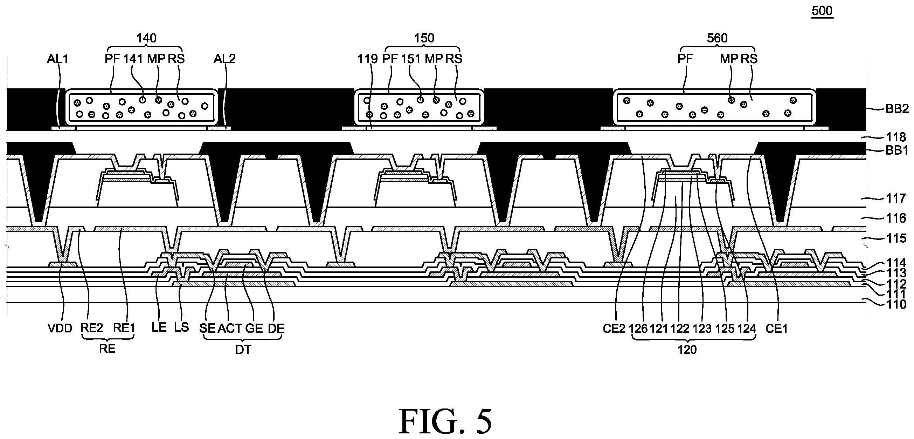

FIG. 5 is a cross-sectional view of one pixel in a display device according to another embodiment of the present disclosure. A display device 500 in FIG. 5 is substantially identical in configuration to the display device 100 in FIGS. 1 to 4, except for a configuration of an assembling block 560. Therefore, a repeated description will be omitted.

With reference to FIG. 5, in the display device 500 according to another embodiment of the present disclosure, the assembling block 560 may be disposed in the blue subpixel SP_B.

In this case, the assembling block 560, the first color conversion block 140, and the second color conversion block 150 may have different sizes or shapes. For example, the assembling block 560, the first color conversion block 140, and the second color conversion block 150 may be identical in shape and different in sizes, or the assembling block 560, the first color conversion block 140, and the second color conversion block 150 may be identical in size and different in shapes. In addition, the assembling block 560, the first color conversion block 140, and the second color conversion block 150 may be different in both sizes and shapes. Therefore, during the process of manufacturing the display device 500 according to another embodiment of the present disclosure, the assembling block 560, the first color conversion block 140, and the second color conversion block 150 may be accurately only in desired subpixels SP_R, SP_G, and SP_B. For example, the first color conversion block 140 may be disposed only in the red subpixel SP_R, the second color conversion block 150 may be disposed only in the green subpixel SP_G, and the assembling block 560 may be disposed only in the blue subpixel SP_B.

The assembling block 560 may not include separate color conversion particles in order to transmit blue light, which is emitted from the light-emitting element 120, in an intact manner without converting the blue light into light with another wavelength.

Therefore, the assembling block 560 may include the plurality of magnetic particles MP, the resin RS in which the plurality of magnetic particles MP is dispersed, and the dielectric film PF made of a dielectric material and configured to surround the plurality of magnetic particles MP and the resin RS.

The plurality of magnetic particles MP may be particles for moving the plurality of assembling blocks 560 to a peripheral area adjacent to the third planarization layer 118 by using magnetic fields during the process of manufacturing the display device 500. Therefore, the plurality of magnetic particles MP may include transition metal such as ferromagnetic particles, ferrimagnetic particles, iron (Fe), cobalt (Co), or nickel (Ni), an oxide including transition metal, and a metal compound including rare-earth atoms such as neodymium (Nd) or samarium (Sm). However, the present disclosure is not limited thereto. One assembling block 560 may include the plurality of magnetic particles MP provided as one type or include the plurality of magnetic particles MP provided as two or more different types. The plurality of magnetic particles MP, which may be included in the assembling block 560, may be identical in type to or different in type from the magnetic particles MP included in the first color conversion block 140 and the second color conversion block 150.

The resin RS may be in a cured state. Therefore, the plurality of magnetic particles MP, which are dispersed in the resin RS, may also be fixed to the resin RS. For example, the resin RS may be acrylic-based resin or epoxy-based resin. However, the present disclosure is not limited thereto. The resin RS, which may be included in the assembling block 560, may be identical in type to or different in type from the resin RS included in the first color conversion block 140 and the second color conversion block 150.

The dielectric material may be the dielectric film PF. The dielectric film PF surrounds the resin RS and the plurality of magnetic particles MP, dispersed in the resin RS, to constitute the assembling block 560. The dielectric film PF may be provided in the form of a thin film made of a dielectric material. For example, the dielectric material may include silicon oxide (SiO₂), silicon carbide (SiC), silicon nitride (SiN), or aluminum oxide (Al₂O₃). However, the present disclosure is not limited thereto. The dielectric film PF, which may be included in the assembling block 560, may be identical in type to or different in type from the dielectric film PF included in the first color conversion block 140 and the second color conversion block 150.

As described above, the display device 500 according to another embodiment of the present disclosure uses a plurality of color conversion blocks 140 and 150 in which the dielectric films PF surround the plurality of color conversion particles 141 and 151. Therefore, it is possible to precisely adjust the densities of the color conversion particles 141 and 151 in the color conversion blocks 140 and 150. In addition, the plurality of color conversion blocks 140 and 150 may suppress the changes in the densities of the color conversion particles 141 and 151 during the manufacturing process. Therefore, it is possible to improve the color conversion efficiency and allow the display device to operate with low power consumption.

In addition, in the display device 500 according to another embodiment of the present disclosure, it is possible to precisely adjust the number of color conversion particles 141 and 151 respectively included in the plurality of color conversion blocks 140 and 150. Therefore, it is possible to improve the color uniformity between the subpixels SP_R, SP_G, and SP_B.

Further, in the display device 500 according to the embodiment of the present disclosure, the plurality of color conversion blocks 140 and 150 may be formed, such that it is not necessary to reduce the sizes of the plurality of color conversion particles 141 and 151. Therefore, a separate process of splitting the plurality of color conversion particles 141 and 151 may be excluded, which may shorten the process time. In addition, it is possible to suppress a loss of the plurality of color conversion particles 141 and 151 that may be caused by the process of splitting the plurality of color conversion particles 141 and 151.

The display device 500 according to another embodiment of the present disclosure may include the plurality of color conversion blocks 140 and 150 and the assembling block 560 that include the dielectric films PF. Therefore, the plurality of color conversion blocks 140 and 150 and the assembling block 560 may have polarities by being dielectrically polarized by the electric fields generated by the plurality of assembling lines AL1 and AL2. As described above, the plurality of color conversion blocks 140 and 150 and the assembling block 560, which are dielectrically polarized, may be fixed or moved in a particular direction by dielectrophoresis (DEP), i.e., the electric field. Therefore, the plurality of color conversion blocks 140 and 150 and the assembling block 560 may be easily fixed onto the third planarization layer 118. As described above, the plurality of color conversion blocks 140 and 150 and the assembling block 560 are self-assembled, which may shorten the process time. In addition, among the processes of manufacturing the display device 500, the process of separately forming the organic layer 160 only in the blue subpixel SP_B may be excluded, which may further shorten the process time.

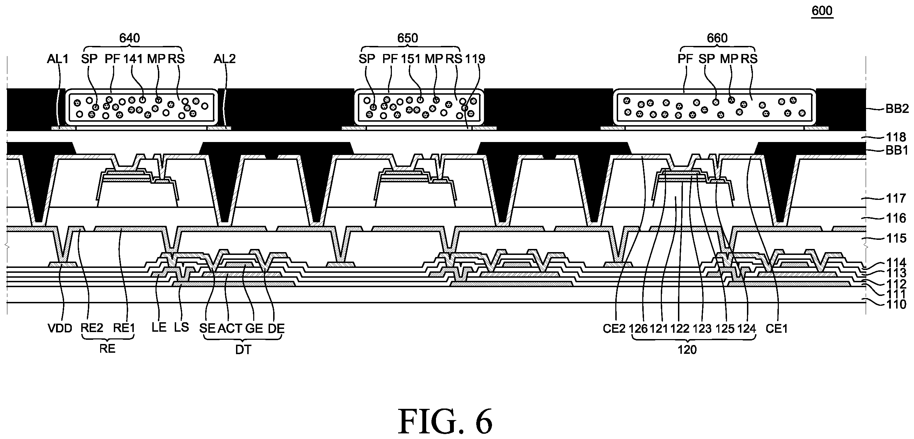

FIG. 6 is a cross-sectional view of one pixel in a display device according to another embodiment of the present disclosure. A display device 600 in FIG. 6 is substantially identical in configuration to the display device 500 in FIG. 5, except for a configuration of scattering particles SP. Therefore, a repeated description will be omitted.

With reference to FIG. 6, the display device 600 according to another embodiment of the present disclosure may further include a plurality of scattering particles SP included in at least any one of a first color conversion block 640, a second color conversion block 650, and an assembling block 660. For example, in the display device 600 according to another embodiment of the present disclosure, all the first color conversion block 640, the second color conversion block 650, and the assembling block 660 may further include the plurality of scattering particles SP.

Titanium oxide (TiO2), zirconium oxide (ZrO2), or the like having nano sizes may be used for the plurality of scattering particles SP. However, the present disclosure is not limited thereto. The scattering particles SP, which may be included in the first color conversion block 640, the second color conversion block 650, and the assembling block 660 may be identical or different in types. In addition, among the plurality of blocks 640, 650, and 660, any one block 640, 650, or 660 may include the plurality of scattering particles SP provided as one type or include the plurality of scattering particles SP provided as two or more different types.

As described above, the display device 600 according to another embodiment of the present disclosure uses a plurality of color conversion blocks 640 and 650 in which the dielectric films PF surround the plurality of color conversion particles 141 and 151. Therefore, it is possible to precisely adjust and maintain the densities of the color conversion particles 141 and 151 in the color conversion blocks 640 and 650. Therefore, it is possible to improve the color conversion efficiency and allow the display device to operate with low power consumption.

In addition, in the display device 600 according to another embodiment of the present disclosure, it is possible to precisely adjust the number of color conversion particles 141 and 151 respectively included in the plurality of color conversion blocks 640 and 650, which may improve the color uniformity between the subpixels SP_R, SP_G, and SP_B.

Further, in the display device 600 according to the embodiment of the present disclosure, the plurality of color conversion blocks 640 and 650 may be formed, such that it is not necessary to reduce the sizes of the plurality of color conversion particles 141 and 151. Therefore, a process of splitting the plurality of color conversion particles 141 and 151 may be excluded. Further, it is possible to suppress a loss of the plurality of color conversion particles 141 and 151 that may be caused by the process of splitting the plurality of color conversion particles 141 and 151.

In addition, in the display device 600 according to another embodiment of the present disclosure, the color conversion blocks 640 and 650 and the assembling block 660 may each include the dielectric film PF. Therefore, the color conversion blocks 640 and 650 and the assembling block 660 may be self-assembled onto the third planarization layer 118 by the electric fields generated by the plurality of assembling lines AL1 and AL2. Therefore, it is possible to shorten the process time.

In the display device 600 according to another embodiment of the present disclosure, the plurality of color conversion blocks 640 and 650 and the plurality of assembling blocks 660 may each further include the plurality of scattering particles SP. The plurality of scattering particles SP may improve the color conversion efficiency by scattering light emitted from the light-emitting element 120 in each of the subpixels SP_R, SP_G, and SP_B. In addition, the light, which has been subjected to the color conversion, is scattered or the light, which is not subjected to the color conversion, is scattered, which may increase a likelihood that the light propagates to the outside. For example, in the red subpixel SP_R or the green subpixel SP_G, the light emitted from the light-emitting element 120 may be scattered by the plurality of scattering particles SP, which may improve the efficiency implemented by the first color conversion particles 141 or the second color conversion particles 151. Furthermore, the converted wavelength may be scattered again by the plurality of scattering particles SP, such that a larger amount of red or green light may be emitted to the outside. Meanwhile, in the blue subpixel SP_B, the light emitted from the light-emitting element 120 may be scattered by the plurality of scattering particles SP, such that a larger amount of blue light may be emitted to the outside. Therefore, it is possible to further improve the light extraction efficiency of the display device 600 and further reduce the power consumption.

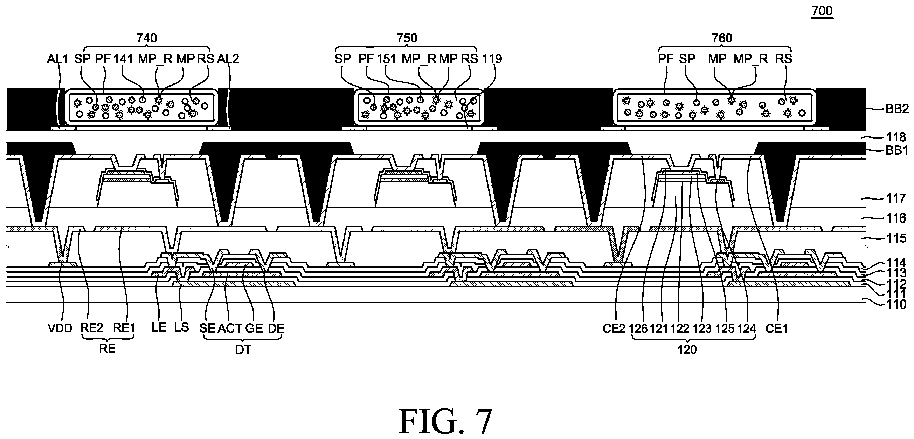

FIG. 7 is a cross-sectional view of one pixel in a display device according to another embodiment of the present disclosure. A display device 700 in FIG. 7 is substantially identical in configuration to the display device 600 in FIG. 6, except for a configuration of magnetic particles. Therefore, a repeated description will be omitted.

With reference to FIG. 7, in the display device 700 according to another embodiment of the present disclosure, a plurality of magnetic particles of at least any one of a first color conversion block 740, a second color conversion block 750, and an assembling block 760 may each include a metal particle MP, and a metal layer MP_R configured to surround the metal particle MP and having higher reflectance than the metal particle. For example, in the display device 700 according to another embodiment of the present disclosure, all the first color conversion block 740, the second color conversion block 750, and the assembling block 760 may include the plurality of magnetic particles each including the metal layer MP_R formed on a surface of the magnetic particle and having high reflectance.

The metal particle MP may be a particle having magnetism and include, for example, transition metal such as ferromagnetic particles, ferrimagnetic particles, iron (Fe), cobalt (Co), or nickel (Ni), an oxide including transition metal, and a metal compound including rare-earth atoms such as neodymium (Nd) or samarium (Sm). However, the present disclosure is not limited thereto.

The type of metal layer MP_R is not specially limited as long as the material of the metal layer MP_R has higher reflectance than the metal particle. The metal layer MP_R may be made of metal having no magnetism.

In the display device 700 according to the embodiment of the present disclosure, the plurality of color conversion blocks 740 and 750, which has the dielectric films PF that surround the plurality of color conversion particles 141 and 151, may be used, which may precisely adjust densities of the color conversion particles 141 and 151 in the color conversion blocks 740 and 750 and suppress the change in the densities. Therefore, it is possible to improve the color conversion efficiency and allow the display device to operate with low power consumption.

In addition, in the display device 700 according to another embodiment of the present disclosure, it is possible to precisely adjust the number of color conversion particles 141 and 151 respectively included in the plurality of color conversion blocks 740 and 750, which may improve the color uniformity between the subpixels SP_R, SP_G, and SP_B.

Further, in the display device 700 according to the embodiment of the present disclosure, the plurality of color conversion blocks 740 and 750 may be formed, such that it is possible to exclude a separate process of splitting the plurality of color conversion particles 141 and 151. In addition, it is possible to suppress a loss of the plurality of color conversion particles 141 and 151 that may be caused by the process of splitting the plurality of color conversion particles 141 and 151.

In the display device 700 according to another embodiment of the present disclosure, the color conversion blocks 740 and 750 and the assembling block 760 may each include the dielectric film PF. Therefore, the color conversion blocks 740 and 750 and the assembling block 760 may be self-assembled by the electric fields generated by the plurality of assembling lines AL1 and AL2. Therefore, it is possible to shorten the process time.

Further, in the display device 700 according to another embodiment of the present disclosure, the first color conversion block 740, the second color conversion block 750, or the assembling block 760 may include the plurality of magnetic particles each including the metal layer MP_R having high reflectance. Therefore, illustrate the reflect the light, emitted from the light-emitting element 120, or the light that has been subjected to the color conversion. For example, in the first color conversion block 740 or the second color conversion block 750, the plurality of magnetic particles, which includes the metal layers MP_R having high reflectance, reflects the light emitted from the light-emitting element 120, such that blue light may be converted into a larger amount of red or green light. Therefore, it is possible to improve the color conversion efficiency of the first color conversion block 740 and the second color conversion block 750. In addition, the converted red or green light may be reflected again by the plurality of magnetic particles including the metal layers having high reflectance, such that a larger amount of red or green light may propagate to the outside. Therefore, it is possible to further improve the light extraction efficiency of the display device 700 and allow the display device to operate with lower power consumption. Meanwhile, in the blue subpixel SP_B, the plurality of magnetic particles, which includes the metal layers MP_R having high reflectance, reflects blue light emitted from the light-emitting element 120, such that a larger amount of blue light may propagate to the outside. Therefore, it is possible to further improve the light extraction efficiency of the display device 700 and allow the display device to operate with lower power consumption.

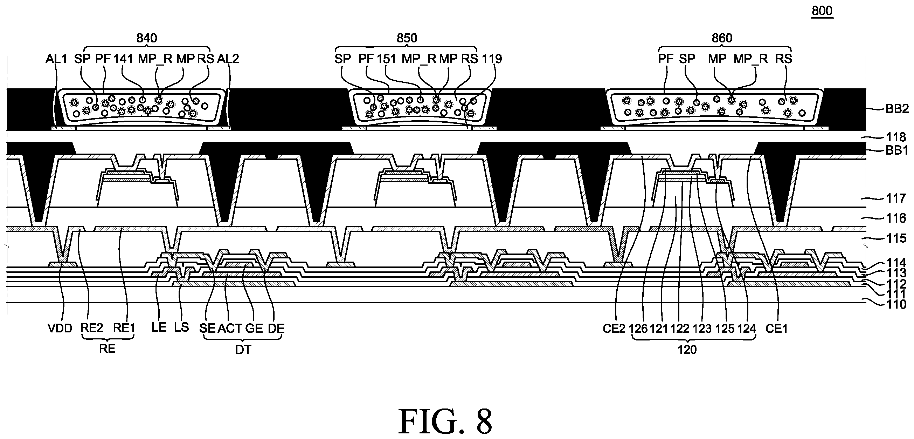

FIG. 8 is a cross-sectional view of one pixel in a display device according to another embodiment of the present disclosure. A display device 800 in FIG. 8 is substantially identical in configuration to the display device 700 in FIG. 7, except for shapes of the second black bank BB2, a first color conversion block 840, a second color conversion block 850, and an assembling block 860. Therefore, repeated descriptions of the identical components will be omitted.

With reference to FIG. 8, a bottom surface of at least one of the first color conversion block 840, the second color conversion block 850, and the assembling block 860 may have a shape convex toward a top surface. In addition, an air layer (air portion) may be disposed between the bonding layer 119 and the bottom surface of at least one of the first color conversion block 840, the second color conversion block 850, and the assembling block 860.

In addition, at least one of the first color conversion block 840, the second color conversion block 850, and the assembling block 860 may have an inversely tapered shape in a cross-sectional view. For example, in a cross-sectional view, the bottom surface of at least one of the first color conversion block 840, the second color conversion block 850, and the assembling block 860 may have a smaller straight width than the top surface thereof.

In the display device 800 according to another embodiment of the present disclosure, at least a part of the second black bank BB2 may have a tapered shape in a cross-sectional view. For convenience of description, the red subpixel SP_R will be described as an example. The second black bank BB2 adjacent to the red subpixel SP_R may have a tapered shape in a cross-sectional view. In addition, the first color conversion block 840 disposed in the red subpixel SP_R may have an inversely tapered shape corresponding to the red subpixel SP_R. For convenience of description, the red subpixel SP_R has been described as an example. However, the above-mentioned description may be equally applied to the green subpixel SP_G and the blue subpixel SP_B without being applied only to the red subpixel SP_R.

As described above, the display device 800 according to another embodiment of the present disclosure uses the plurality of color conversion blocks 840 and 850 in which the dielectric films PF surround the plurality of color conversion particles 141 and 151. Therefore, it is possible to precisely adjust the densities of the color conversion particles 141 and 151 in the color conversion blocks 840 and 850 and suppress the change in the densities. Therefore, it is possible to improve the color conversion efficiency and allow the display device to operate with low power consumption.

In addition, in the display device 800 according to another embodiment of the present disclosure, it is possible to precisely adjust the number of color conversion particles 141 and 151 respectively included in the plurality of color conversion blocks 840 and 850, which may improve the color uniformity between the subpixels SP_R, SP_G, and SP_B.

Further, in the display device 800 according to the embodiment of the present disclosure, the plurality of color conversion blocks 840 and 850 may be formed. Therefore, a separate process of splitting the plurality of color conversion particles 141 and 151 may be excluded. Further, it is possible to suppress a loss of the plurality of color conversion particles 141 and 151 that may be caused by the process of splitting the plurality of color conversion particles 141 and 151.

In addition, in the display device 800 according to another embodiment of the present disclosure, the color conversion blocks 840 and 850 and the assembling block 860 may each include the dielectric film PF. Therefore, the color conversion blocks 840 and 850 and the assembling block 860 may be self-assembled by the electric fields generated by the plurality of assembling lines AL1 and AL2. Therefore, it is possible to shorten the process time.

Meanwhile, when the light emitted from the light-emitting element 120 enters the first color conversion block 840, the second color conversion block 850, or the assembling block 860, the wavelength is converted by the first color conversion particles 141 or the second color conversion particles 151, or the light is scattered by the scattering particles SP or the magnetic particles. A part of the light, which is converted or scattered as described above, may propagate toward the bottom surface of the first color conversion block 840, the second color conversion block 850, or the assembling block 860. In this case, in the display device 800 according to another embodiment of the present disclosure, the bottom surface of any one of the first color conversion block 840, the second color conversion block 850, and the assembling block 860 has a convex shape, such that the light emitted to the bottom surface may be totally reflected into the first color conversion block 840, the second color conversion block 850, or the assembling block 860 by a difference in refractive indexes between the resin RS, the dielectric film PF, and the air layer and a shape of a convex lens of the bottom surface. Therefore, it is possible to suppress a loss of light. Therefore, it is possible to further improve the light extraction efficiency of the display device 800 and improve the color purity. In addition, the improvement of the light extraction efficiency may allow the display device to operate with lower power consumption.

In addition, in the display device 800 according to another embodiment of the present disclosure, at least a part of the second black bank BB2 may have a tapered shape in a cross-sectional view. Therefore, in case that the plurality of color conversion blocks 840 and 850 or the assembling block 860 is self-assembled during the process of manufacturing the display device 800, the plurality of color conversion blocks 840 and 850 or the assembling block 860 may be disposed on the third planarization layer 118 so that the surface having the convex shape is the bottom surface in a cross-sectional view without a separate additional process.

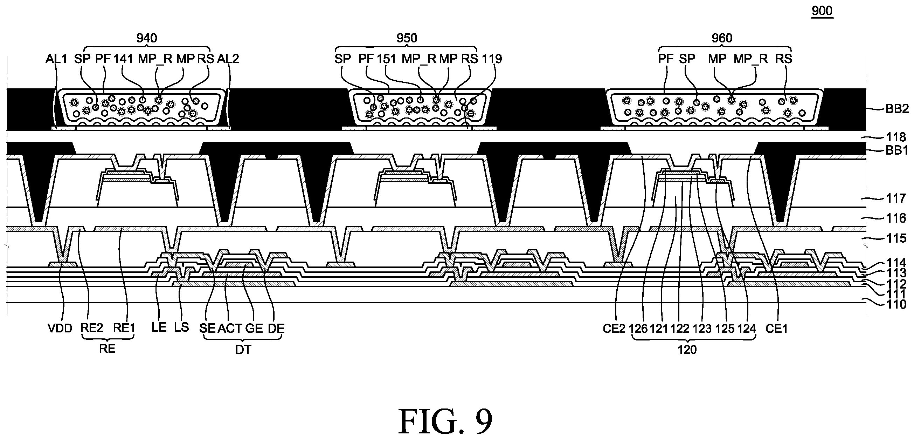

FIG. 9 is a cross-sectional view of one pixel in a display device according to another embodiment of the present disclosure. A display device 900 in FIG. 9 is substantially identical in configuration to the display device 800 in FIG. 8, except for shapes of a first color conversion block 940, a second color conversion block 950, and an assembling block 960. Therefore, repeated descriptions of the identical components will be omitted.

With reference to FIG. 9, in the display device 900 according to another embodiment of the present disclosure, a bottom surface of at least one of the first color conversion block 940, the second color conversion block 950, and the assembling block 960 may include a plurality of convex surfaces in a cross-sectional view. In addition, in at least one of the plurality of color conversion blocks 940 and 950 and the assembling block 960, a plurality of air layers may be disposed between the bottom surface having the convex shape and the top surface of the bonding layer 119.

As described above, the display device 900 according to another embodiment of the present disclosure uses the plurality of color conversion blocks 940 and 950 in which the dielectric films PF surround the plurality of color conversion particles 141 and 151. Therefore, it is possible to precisely adjust the densities of the color conversion particles 141 and 151 in the color conversion blocks 940 and 950 and suppress the change in the densities. Therefore, it is possible to improve the color conversion efficiency and allow the display device to operate with low power consumption.

In addition, in the display device 900 according to another embodiment of the present disclosure, it is possible to precisely adjust the number of color conversion particles 141 and 151 respectively included in the plurality of color conversion blocks 940 and 950, which may improve the color uniformity between the subpixels SP_R, SP_G, and SP_B.

Further, in the display device 900 according to the embodiment of the present disclosure, the plurality of color conversion blocks 940 and 950 may be formed, such that it is possible to exclude a separate process of splitting the plurality of color conversion particles 141 and 151.

In addition, in the display device 900 according to another embodiment of the present disclosure, the color conversion blocks 940 and 950 and the assembling block 960 may each include the dielectric film PF. Therefore, the color conversion blocks 940 and 950 and the assembling block 960 may be self-assembled onto the third planarization layer 118 by the electric fields generated by the plurality of assembling lines AL1 and AL2. Therefore, it is possible to shorten the process time.

Further, in the display device 900 according to another embodiment of the present disclosure, the bottom surface of the first color conversion block 940, the second color conversion block 950, or the assembling block 960 includes the plurality of convex surfaces, such that the amount of light to be totally reflected by the bottom surface may be increased. Therefore, it is possible to further suppress a loss of light propagating toward the bottom surface of the first color conversion block 940, the second color conversion block 950, or the assembling block 960. In addition, it is possible to further improve the light extraction efficiency of the display device 900 and further improve the color purity. Therefore, it is possible to further reduce the power consumption.

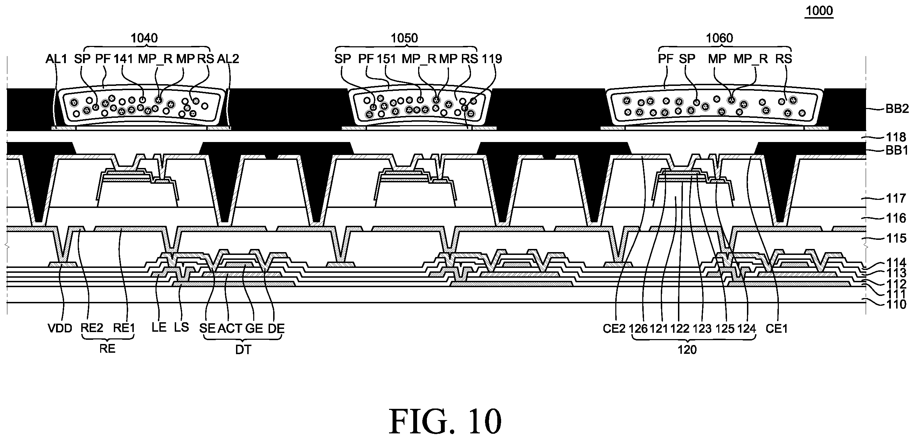

FIG. 10 is a cross-sectional view of one pixel in a display device according to another embodiment of the present disclosure. A display device 1000 in FIG. 10 is substantially identical in configuration to the display device 800 in FIG. 8, except for shapes of a first color conversion block 1040, a second color conversion block 1050, and an assembling block 1060. Therefore, repeated descriptions of the identical components will be omitted.

With reference to FIG. 10, in the display device 1000 according to another embodiment of the present disclosure, a top surface of any one of the first color conversion block 1040, the second color conversion block 1050, and the assembling block 1060 may have a convex shape. For convenience of description, FIG. 10 illustrates that the top surface has a single convex shape. However, the present disclosure is not limited thereto. For example, in the display device 1000 according to another example of the present disclosure, the top surface of the first color conversion block 1040, the second color conversion block 1050, or the assembling block 1060 may include a plurality of convex surfaces.

As described above, the display device 1000 according to another embodiment of the present disclosure uses the plurality of color conversion blocks 1040 and 1050 in which the dielectric films PF surround the plurality of color conversion particles 141 and 151. Therefore, it is possible to precisely adjust the densities of the color conversion particles 141 and 151 in the color conversion blocks 1040 and 1050 and suppress the change in the densities. Therefore, it is possible to improve the color conversion efficiency and allow the display device to operate with low power consumption.

In addition, in the display device 1000 according to another embodiment of the present disclosure, it is possible to precisely adjust the number of color conversion particles 141 and 151 respectively included in the plurality of color conversion blocks 1040 and 1050, which may improve the color uniformity between the subpixels SP_R, SP_G, and SP_B.

Further, in the display device 1000 according to the embodiment of the present disclosure, the plurality of color conversion blocks 1040 and 1050 may be formed, such that it is possible to exclude a separate process of splitting the plurality of color conversion particles 141 and 151. Further, it is possible to suppress a loss of the plurality of color conversion particles 141 and 151 that may be caused by the process of splitting the plurality of color conversion particles 141 and 151.

In addition, in the display device 1000 according to another embodiment of the present disclosure, the color conversion blocks 1040 and 1050 and the assembling block 1060 may each include the dielectric film PF. Therefore, the color conversion blocks 1040 and 1050 and the assembling block 1060 may be self-assembled onto the third planarization layer 118 by the electric fields generated by the plurality of assembling lines AL1 and AL2. Therefore, it is possible to shorten the process time.

Further, in the display device 1000 according to another embodiment of the present disclosure, the top surface of the first color conversion block 1040, the second color conversion block 1050, or the assembling block 1060 includes the convex surface, such that the light emitted to the outside, i.e., the top surface of each of the blocks 1040, 1050, and 1060 may be collected in the direction of the front surface. Therefore, it is possible to further improve the front brightness of the display device 1000.

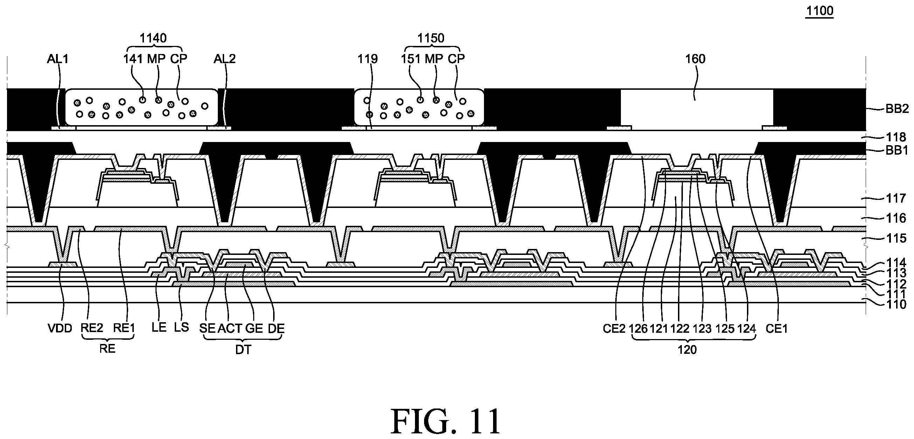

FIG. 11 is a cross-sectional view of one pixel in a display device according to another embodiment of the present disclosure. A display device 1100 in FIG. 11 is substantially identical in configuration to the display device 100 in FIGS. 1 to 4, except for configurations of a first color conversion block 1140 and a second color conversion block 1150. Therefore, repeated descriptions of the identical components will be omitted.

With reference to FIG. 11, in the first color conversion block 1140 and the second color conversion block 1150 of the display device 1100 according to another embodiment of the present disclosure, the plurality of magnetic particles MP, together with the plurality of first color conversion particles 141 or the second color conversion particles 151, may be dispersed and fixed in a solid dielectric material CP.

The solid dielectric material CP may be made by curing a dielectric material. For example, the dielectric material may include silicon oxide (SiO₂), silicon carbide (SiC), silicon nitride (SiN), or aluminum oxide (Al₂O₃). However, the present disclosure is not limited thereto.

As described above, the display device 1100 according to another embodiment of the present disclosure uses the plurality of color conversion blocks 1140 and 1150 each including the solid dielectric material CP in which the plurality of color conversion particles 141 and 151 is dispersed. Therefore, it is possible to precisely adjust the densities of the color conversion particles 141 and 151 in the color conversion blocks 1140 and 1150 and suppress the change in the densities. Therefore, it is possible to improve the color conversion efficiency and allow the display device to operate with low power consumption.

In addition, in the display device 1100 according to another embodiment of the present disclosure, it is possible to precisely adjust the number of color conversion particles 141 and 151 respectively included in the plurality of color conversion blocks 1140 and 1150, which may improve the color uniformity between the subpixels SP_R, SP_G, and SP_B.

Further, in the display device 1100 according to the embodiment of the present disclosure, the plurality of color conversion blocks 1140 and 1150 may be formed, such that it is possible to exclude a separate process of splitting the plurality of color conversion particles 141 and 151. Further, it is possible to suppress a loss of the plurality of color conversion particles 141 and 151 that may be caused by the process of splitting the plurality of color conversion particles 141 and 151.

In addition, in the display device 1100 according to another embodiment of the present disclosure, the color conversion blocks 1140 and 1150 may each include the solid dielectric material CP. Therefore, the color conversion blocks 1140 and 1150 may be self-assembled onto the third planarization layer 118 by the electric fields generated by the plurality of assembling lines AL1 and AL2. Therefore, it is possible to shorten the process time.

Furthermore, in the color conversion blocks 1140 and 1150 of the display device 1100 according to another embodiment of the present disclosure, the plurality of color conversion particles 141 and 151 and the plurality of magnetic particles MP are dispersed in the solid dielectric materials CP, such that the components in the color conversion blocks 1140 and 1150 may be uniformly dispersed, and the uniform dispersity may be maintained. Therefore, it is possible to further improve the color uniformity of the display device 1100. In addition, because the dielectric material CP is formed to be solid, the shapes of the color conversion blocks 1140 and 1150 may be advantageously processed, and a separate process of forming a dielectric film may be excluded, which may shorten the process time. In addition, it is possible to improve the reliability related to external environments, such as a temperature or humidity, in comparison with resin.

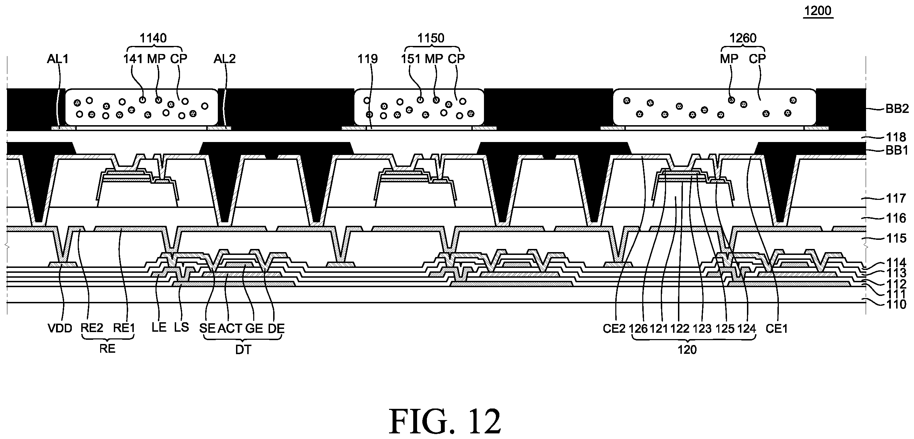

FIG. 12 is a cross-sectional view of one pixel in a display device according to another embodiment of the present disclosure. A display device 1200 in FIG. 12 is substantially identical in configuration to the display device 1100 in FIG. 11, except for a configuration of an assembling block 1260. Therefore, a repeated description will be omitted.

With reference to FIG. 12, in the display device 1200 according to another embodiment of the present disclosure, the assembling block 1260 may be further included in the blue subpixel SP_B.

As described above, the display device 1200 according to another embodiment of the present disclosure uses the plurality of color conversion blocks 1140 and 1150 each including the solid dielectric material CP in which the plurality of color conversion particles 141 and 151 is dispersed. Therefore, it is possible to precisely adjust the densities of the color conversion particles 141 and 151 in the color conversion blocks 1140 and 1150 and suppress the change in the densities. Therefore, it is possible to improve the color conversion efficiency and allow the display device to operate with low power consumption.

In addition, in the display device 1200 according to another embodiment of the present disclosure, it is possible to precisely adjust the number of color conversion particles 141 and 151 respectively included in the plurality of color conversion blocks 1140 and 1150, which may improve the color uniformity between the subpixels SP_R, SP_G, and SP_B.

Further, in the display device 1200 according to the embodiment of the present disclosure, the plurality of color conversion blocks 1140 and 1150 may be formed, such that it is possible to exclude a separate process of splitting the plurality of color conversion particles 141 and 151. Further, it is possible to suppress a loss of the plurality of color conversion particles 141 and 151 that may be caused by the process of splitting the plurality of color conversion particles 141 and 151.

In addition, the display device 1200 according to another embodiment of the present disclosure may include the plurality of color conversion blocks 1140 and 1150 and the assembling block 1260 each including the solid dielectric material CP. Therefore, the plurality of color conversion blocks 1140 and 1150 and the assembling block 1260 may be self-assembled onto the third planarization layer 118 by the electric fields generated by the plurality of assembling lines AL1 and AL2. Therefore, it is possible to shorten the process time. In addition, among the processes of manufacturing the display device 1200, the process of separately forming the organic layer 160 only in the blue subpixel SP_B may be excluded, which may further shorten the process time.

Furthermore, in the plurality of color conversion blocks 1140 and 1150 and the assembling block 1260 of the display device 1200 according to another embodiment of the present disclosure, the plurality of color conversion particles 141 and 151 or the plurality of magnetic particles MP may be dispersed in the solid dielectric materials CP. Therefore, the plurality of color conversion particles 141 and 151 or the plurality of magnetic particles MP may be more uniformly dispersed in the assembling block 1260, and the uniform dispersity may be maintained. Therefore, it is possible to further improve the color uniformity of the display device 1200. In addition, because the dielectric material is formed to be solid, the shapes of the assembling block 1260 may be advantageously processed, and a separate process of forming a dielectric film may be excluded, which may shorten the process time. In addition, it is possible to improve the reliability related to external environments, such as a temperature or humidity, in comparison with resin.

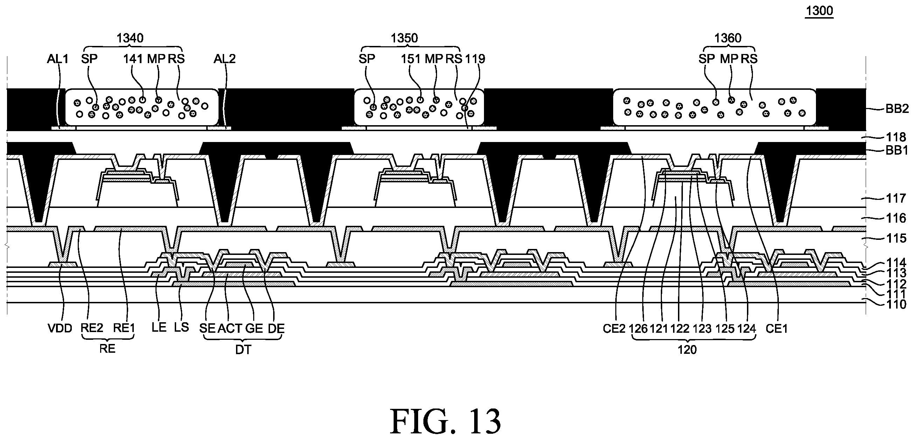

FIG. 13 is a cross-sectional view of one pixel in a display device according to another embodiment of the present disclosure. A display device 1300 in FIG. 13 is substantially identical in configuration to the display device 1200 in FIG. 12, except for configurations of a first color conversion block 1340, a second color conversion block 1350, and an assembling block 1360. Therefore, repeated descriptions of the identical components will be omitted.

With reference to FIG. 13, in the display device 1300 according to another embodiment of the present disclosure, the first color conversion block 1340, the second color conversion block 1350, and the assembling block 1360 may each further include the scattering particles SP. Because the specific configurations of the scattering particles SP are substantially identical to those described above, a repeated description will be omitted.

As described above, the display device 1300 according to another embodiment of the present disclosure uses the plurality of color conversion blocks 1340 and 1350 each including the solid dielectric material CP in which the plurality of color conversion particles 141 and 151 is dispersed. Therefore, it is possible to precisely adjust the densities of the color conversion particles 141 and 151 in the color conversion blocks 1340 and 1350 and suppress the change in the densities. Therefore, it is possible to improve the color conversion efficiency and allow the display device to operate with low power consumption.

In addition, in the display device 1300 according to another embodiment of the present disclosure, it is possible to precisely adjust the number of color conversion particles 141 and 151 respectively included in the plurality of color conversion blocks 1340 and 1350, which may improve the color uniformity between the subpixels SP_R, SP_G, and SP_B.

Further, in the display device 1300 according to the embodiment of the present disclosure, the plurality of color conversion blocks 1340 and 1350 may be formed, such that it is possible to exclude a separate process of splitting the plurality of color conversion particles 141 and 151. Further, it is possible to suppress a loss of the plurality of color conversion particles 141 and 151 that may be caused by the process of splitting the plurality of color conversion particles 141 and 151.

In addition, in the display device 1300 according to another embodiment of the present disclosure, the color conversion blocks 1340 and 1350 and the assembling block 1360 may each include the solid dielectric material CP. Therefore, the color conversion blocks 1340 and 1350 and the assembling block 1360 may be self-assembled onto the third planarization layer 118 by the electric fields generated by the plurality of assembling lines AL1 and AL2. Therefore, it is possible to shorten the process time.

In the display device 1300 according to another embodiment of the present disclosure, the plurality of color conversion blocks 1340 and 1350 and the plurality of assembling blocks 1360 may each further include the plurality of scattering particles SP. The plurality of scattering particles SP may improve the color conversion efficiency by scattering light emitted from the light-emitting element 120 in each of the subpixels SP_R, SP_G, and SP_B. Therefore, it is possible to further improve the light extraction efficiency of the display device 1300 and further reduce the power consumption.

Furthermore, in the plurality of color conversion blocks 1340 and 1350 and the assembling block 1360 of the display device 1300 according to another embodiment of the present disclosure, the plurality of color conversion particles 141 and 151, the plurality of scattering particles SP, or the plurality of magnetic particles MP may be dispersed in the solid dielectric materials CP. Therefore, the plurality of color conversion particles 141 and 151, the plurality of scattering particles SP, or the plurality of magnetic particles MP may be more uniformly dispersed, and the uniform dispersity may be maintained. Therefore, it is possible to improve the color uniformity of the display device 1300. In addition, because the dielectric material is formed to be solid, the shapes of the assembling block 1360 may be advantageously processed, and a separate process of forming a dielectric film may be excluded, which may shorten the process time. In addition, it is possible to improve the reliability related to external environments, such as a temperature or humidity, in comparison with resin.

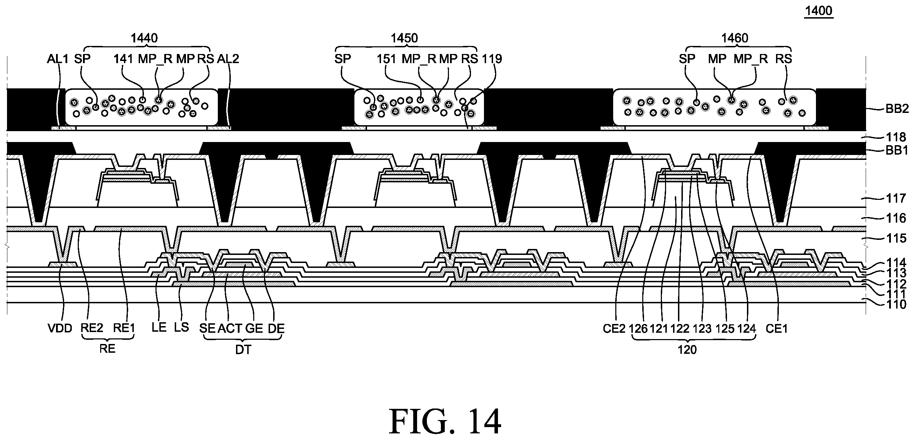

FIG. 14 is a cross-sectional view of one pixel in a display device according to another embodiment of the present disclosure. A display device 1400 in FIG. 14 is substantially identical in configuration to the display device 1300 in FIG. 13, except for configurations of a first color conversion block 1440, a second color conversion block 1450, and an assembling block 1460. Therefore, repeated descriptions of the identical components will be omitted.

With reference to FIG. 14, in the display device 1400 according to another embodiment of the present disclosure, a plurality of magnetic particles of at least any one of a first color conversion block 1440, a second color conversion block 1450, and an assembling block 1460 may each include a metal particle MP, and a metal layer MP_R configured to surround the metal particle MP and having higher reflectance than the metal particle. In this case, because the specific configurations of the metal particle MP and the metal layer MP_R are substantially identical to those described above, a repeated description will be omitted.

As described above, the display device 1400 according to another embodiment of the present disclosure uses the plurality of color conversion blocks 1440 and 1450 each including the solid dielectric material CP in which the plurality of color conversion particles 141 and 151 is dispersed. Therefore, it is possible to precisely adjust the densities of the color conversion particles 141 and 151 in the color conversion blocks 1440 and 1450 and suppress the change in the densities. Therefore, it is possible to improve the color conversion efficiency and allow the display device to operate with low power consumption.

In addition, in the display device 1400 according to another embodiment of the present disclosure, it is possible to precisely adjust the number of color conversion particles 141 and 151 respectively included in the plurality of color conversion blocks 1440 and 1450, which may improve the color uniformity between the subpixels SP_R, SP_G, and SP_B.

Further, in the display device 1400 according to the embodiment of the present disclosure, the plurality of color conversion blocks 1440 and 1450 may be formed, such that it is possible to exclude a separate process of splitting the plurality of color conversion particles 141 and 151. Further, it is possible to suppress a loss of the plurality of color conversion particles 141 and 151 that may be caused by the process of splitting the plurality of color conversion particles 141 and 151.

In addition, in the display device 1400 according to another embodiment of the present disclosure, the color conversion blocks 1440 and 1450 and the assembling block 1460 may each include the solid dielectric material CP. Therefore, the color conversion blocks 1440 and 1450 and the assembling block 1460 may be self-assembled onto the third planarization layer 118 by the electric fields generated by the plurality of assembling lines AL1 and AL2. Therefore, it is possible to shorten the process time.

Further, in the display device 1400 according to another embodiment of the present disclosure, the first color conversion block 1440, the second color conversion block 1450, or the assembling block 1460 may include the plurality of magnetic particles each including the metal layer MP_R having high reflectance, such that the color conversion efficiency may be improved. In addition, it is possible to further improve the light extraction efficiency of the display device 1400 and allow the display device to operate with lower power consumption.

In the blue subpixel SP_B, the plurality of magnetic particles, which includes the metal layers MP_R having high reflectance, may reflect blue light emitted from the light-emitting element 120. It is possible to further improve the light extraction efficiency of the display device 700 and allow the display device to operate with lower power consumption.

Furthermore, in the plurality of color conversion blocks 1440 and 1450 and the assembling block 1360 of the display device 1400 according to another embodiment of the present disclosure, the plurality of color conversion particles 141 and 151, the plurality of scattering particles SP, or the plurality of magnetic particles may be dispersed in the solid dielectric materials CP. Therefore, the plurality of color conversion particles 141 and 151, the plurality of scattering particles SP, or the plurality of magnetic particles may be more uniformly dispersed, and the uniform dispersity may be maintained. Therefore, it is possible to improve the color uniformity of the display device 1400. In addition, because the dielectric material is formed to be solid, the shapes of the assembling block 1460 may be advantageously processed, and a separate process of forming a dielectric film may be excluded, which may shorten the process time. In addition, it is possible to improve the reliability related to external environments, such as a temperature or humidity, in comparison with resin.

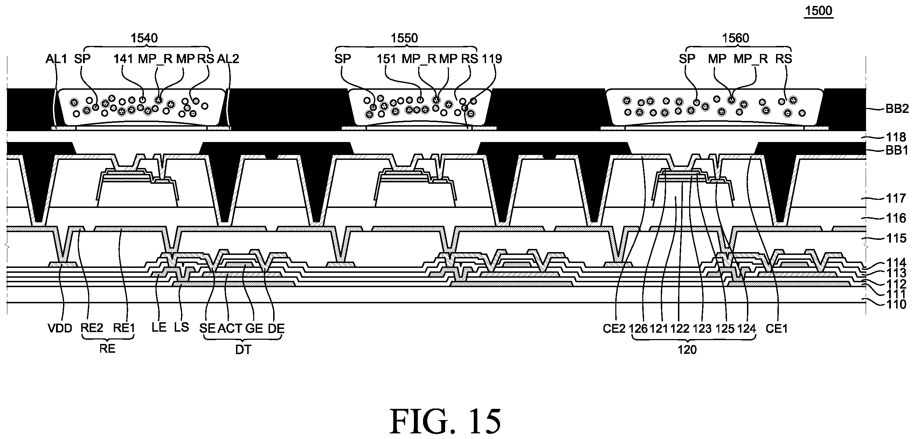

FIG. 15 is a cross-sectional view of one pixel in a display device according to another embodiment of the present disclosure. A display device 1500 in FIG. 15 is substantially identical in configuration to the display device 1400 in FIG. 14, except for shapes of the second black bank BB2, a first color conversion block 1540, a second color conversion block 1550, and an assembling block 1560. Therefore, repeated descriptions of the identical components will be omitted.

In addition, because the shapes of the second black bank BB2, the first color conversion block 1540, the second color conversion block 1550, and the assembling block 1560 of the display device 1500 in FIG. 15 are substantially identical to those of the display device 800 in FIG. 8, a repeated description will be omitted.

As described above, the display device 1500 according to another embodiment of the present disclosure uses the plurality of color conversion blocks 1540 and 1550 each including the solid dielectric material CP in which the plurality of color conversion particles 141 and 151 is dispersed. Therefore, it is possible to precisely adjust the densities of the color conversion particles 141 and 151 in the color conversion blocks 1540 and 1550 and suppress the change in the densities. Therefore, it is possible to improve the color conversion efficiency and allow the display device to operate with low power consumption.

In addition, in the display device 1500 according to another embodiment of the present disclosure, it is possible to precisely adjust the number of color conversion particles 141 and 151 respectively included in the plurality of color conversion blocks 1540 and 1550, which may improve the color uniformity between the subpixels SP_R, SP_G, and SP_B.

Further, in the display device 1500 according to the embodiment of the present disclosure, the plurality of color conversion blocks 1540 and 1550 may be formed, such that it is possible to exclude a separate process of splitting the plurality of color conversion particles 141 and 151. Further, it is possible to suppress a loss of the plurality of color conversion particles 141 and 151 that may be caused by the process of splitting the plurality of color conversion particles 141 and 151.

In addition, in the display device 1500 according to another embodiment of the present disclosure, the color conversion blocks 1540 and 1550 and the assembling block 1560 may each include the solid dielectric material CP. Therefore, the color conversion blocks 1540 and 1550 and the assembling block 1560 may be self-assembled onto the third planarization layer 118 by the electric fields generated by the plurality of assembling lines AL1 and AL2. Therefore, it is possible to shorten the process time.

Furthermore, in the display device 1500 according to another embodiment of the present disclosure, the bottom surface of any one of the first color conversion block 1540, the second color conversion block 1550, and the assembling block 1560 has the convex shape, such that a loss of light propagating toward the bottom surface may be suppressed. Therefore, it is possible to further improve the light extraction efficiency of the display device 1500 and improve the color purity.

In addition, in the display device 1500 according to another embodiment of the present disclosure, at least a part of the second black bank BB2 may have a tapered shape in a cross-sectional view. Therefore, the plurality of color conversion blocks 1540 and 1550 or the assembling block 1560 may be disposed on the third planarization layer 118 so that the surface having the convex shape is the bottom surface in a cross-sectional view without a separate additional process.

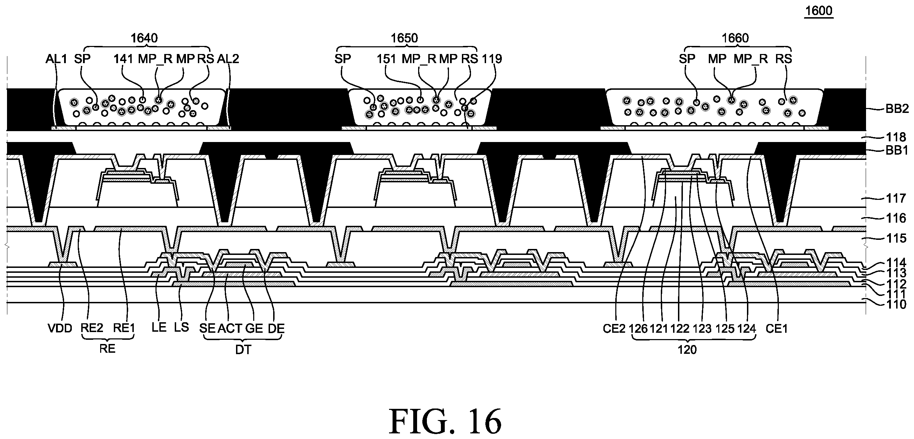

FIG. 16 is a cross-sectional view of one pixel in a display device according to another embodiment of the present disclosure. A display device 1600 in FIG. 16 is substantially identical in configuration to the display device 1500 in FIG. 15, except for shapes of the second black bank BB2, a first color conversion block 1640, a second color conversion block 1650, and an assembling block 1660. Therefore, repeated descriptions of the identical components will be omitted.

In addition, because the shapes of the second black bank BB2, the first color conversion block 1640, the second color conversion block 1650, and the assembling block 1660 of the display device 1600 in FIG. 16 are substantially identical to those of the display device 900 in FIG. 9, a repeated description will be omitted.

As described above, the display device 1600 according to another embodiment of the present disclosure uses the plurality of color conversion blocks 1640 and 1650 each including the solid dielectric material CP in which the plurality of color conversion particles 141 and 151 is dispersed. It is possible to precisely adjust the densities of the color conversion particles 141 and 151 in the color conversion blocks 1640 and 1650 and suppress the change in the densities. Therefore, it is possible to improve the color conversion efficiency and allow the display device to operate with low power consumption.

In addition, in the display device 1600 according to another embodiment of the present disclosure, it is possible to precisely adjust the number of color conversion particles 141 and 151 respectively included in the plurality of color conversion blocks 1640 and 1650, which may improve the color uniformity between the subpixels SP_R, SP_G, and SP_B.

Further, in the display device 1600 according to the embodiment of the present disclosure, the plurality of color conversion blocks 1640 and 1650 may be formed, such that it is possible to exclude a separate process of splitting the plurality of color conversion particles 141 and 151. Further, it is possible to suppress a loss of the plurality of color conversion particles 141 and 151 that may be caused by the process of splitting the plurality of color conversion particles 141 and 151.

In addition, in the display device 1600 according to another embodiment of the present disclosure, the color conversion blocks 1640 and 1650 and the assembling block 1660 may each include the solid dielectric material CP. Therefore, the color conversion blocks 1640 and 1650 and the assembling block 1660 may be self-assembled onto the third planarization layer 118 by the electric fields generated by the plurality of assembling lines AL1 and AL2. Therefore, it is possible to shorten the process time.

Further, in the display device 1600 according to another embodiment of the present disclosure, the bottom surface of the first color conversion block 1640, the second color conversion block 1650, or the assembling block 1660 includes the plurality of convex surfaces, such that the amount of light to be totally reflected by the bottom surface may be increased. Therefore, it is possible to further improve the light extraction efficiency of the display device 1600 and further improve the color purity. Therefore, it is possible to further reduce the power consumption.

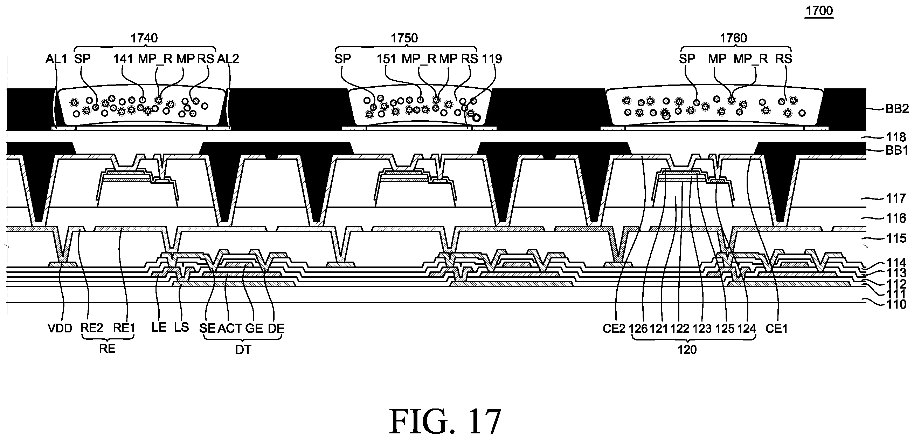

FIG. 17 is a cross-sectional view of one pixel in a display device according to another embodiment of the present disclosure. A display device 1700 in FIG. 17 is substantially identical in configuration to the display device 1600 in FIG. 16, except for shapes of the second black bank BB2, a first color conversion block 1740, a second color conversion block 1750, and an assembling block 1760. Therefore, repeated descriptions of the identical components will be omitted.

In addition, because the shapes of the second black bank BB2, the first color conversion block 1740, the second color conversion block 1750, and the assembling block 1760 of the display device 1700 in FIG. 17 are substantially identical to those of the display device 1000 in FIG. 10, a repeated description will be omitted.

As described above, the display device 1700 according to another embodiment of the present disclosure uses the plurality of color conversion blocks 1740 and 1750 having the solid dielectric materials in which the plurality of color conversion particles 141 and 151 is dispersed, which may precisely adjust densities of the color conversion particles 141 and 151 in the color conversion blocks 1740 and 1750 and suppress the change in the densities. Therefore, it is possible to improve the color conversion efficiency and allow the display device to operate with low power consumption.

In addition, in the display device 1700 according to another embodiment of the present disclosure, it is possible to precisely adjust the number of color conversion particles 141 and 151 respectively included in the plurality of color conversion blocks 1740 and 1750, which may improve the color uniformity between the subpixels SP_R, SP_G, and SP_B.

Further, in the display device 1700 according to the embodiment of the present disclosure, the plurality of color conversion blocks 1740 and 1750 may be formed, such that it is possible to exclude a separate process of splitting the plurality of color conversion particles 141 and 151, which may shorten the process time. Further, it is possible to suppress a loss of the plurality of color conversion particles 141 and 151 that may be caused by the process of splitting the plurality of color conversion particles 141 and 151.

In addition, in the display device 1700 according to another embodiment of the present disclosure, the color conversion blocks 1740 and 1750 and the assembling block 1760 may each include the solid dielectric material CP. Therefore, the color conversion blocks 1740 and 1750 and the assembling block 1760 may be self-assembled onto the third planarization layer 118 by the electric fields generated by the plurality of assembling lines AL1 and AL2. Therefore, it is possible to shorten the process time.

Further, in the display device 1700 according to another embodiment of the present disclosure, the top surface of the first color conversion block 1740, the second color conversion block 1750, or the assembling block 1760 includes the convex surface, such that the light emitted to the outside, i.e., the top surface of each of the blocks 1740, 1750, and 1760 may be collected in the direction of the front surface. Therefore, it is possible to further improve the front brightness of the display device 1700.

The exemplary embodiments of the present disclosure can also be described as follows:

According to an aspect of the present disclosure, there is provided a display device. The display device comprises a substrate on which a plurality of subpixels is defined, a plurality of light-emitting elements at least one of which is disposed in a corresponding subpixle of the plurality of subpixels on the substrate, and a plurality of color conversion blocks disposed on at least one light-emitting element among the plurality of light-emitting elements and configured to convert a wavelength of light emitted from the light-emitting element, wherein the plurality of color conversion blocks comprise: a plurality of color conversion particles, a plurality of magnetic particles, and a dielectric material configured to surround the plurality of color conversion particles and the plurality of magnetic particles.

According to another aspect of the present disclosure, there is provided a display device. The display device comprises a substrate, a plurality of light-emitting elements, emitting light of the same color, disposed on the substrate, the plurality of light-emitting elements corresponding to a plurality of subpixels and comprising a first light-emitting element and a second light-emitting element, a color conversion block disposed on the first light-emitting element and configured to convert a wavelength of light emitted from the first light-emitting element, and an assembling block disposed on the second light-emitting element and configured to transmit light emitted from the second light-emitting element without undergoing wavelength conversion, wherein the color conversion block comprises a plurality of color conversion particles, a plurality of magnetic particles, and a dielectric material configured to surround the plurality of color conversion particles and the plurality of magnetic particles.

The display device according to any one of these aspects may include one or more of the following features:

Each of the plurality of color conversion blocks may further comprise resin in which the plurality of color conversion particles and the plurality of magnetic particles may be dispersed. The dielectric material may be a dielectric film configured to surround the resin.

Each of the color conversion blocks may have a shape or configuration in which the plurality of color conversion particles and the plurality of magnetic particles are fixed and/or dispersed in the dielectric material, e.g. the dielectric material being a solid dielectric material.

Each of the plurality of magnetic particles may comprise a metal particle. Each of the plurality of magnetic particles may comprise further a metal layer configured to surround the metal particle and having higher reflectance than the metal particle.

Each of the color conversion blocks may further comprise a plurality of scattering particles.

The display device may further comprise a planarization layer disposed on the plurality of light-emitting elements. The display device may further comprise a plurality of assembling lines provided on the planarization layer and disposed at one side and the other side of at least one light-emitting element among the plurality of light-emitting elements.

The display device may further comprise a black bank configured to cover one end of each of the plurality of assembling lines.

The plurality of color conversion blocks may be disposed on the planarization layer and overlaps the plurality of assembling lines.

The display device may further comprise a bonding layer disposed between the planarization layer and the plurality of color conversion blocks.

In a cross-sectional view, each of the color conversion blocks may have an inversely tapered shape. A width of a bottom surface of each of the color conversion block may be smaller than a width of a top surface of each of the color conversion block.

In a cross-sectional view, the black bank may have a tapered shape. Each of the plurality of color conversion blocks may have an inversely tapered shape corresponding to the tapered shape of the black bank.

A bottom surface of each of the plurality of color conversion blocks may include one or more convex surfaces.

A top surface of each of the plurality of color conversion blocks may include a convex surface.

The plurality of subpixels may comprise a red subpixel, a green subpixel, and a blue subpixel, wherein the plurality of light-emitting elements may be blue light-emitting elements configured to emit blue light, and wherein the plurality of color conversion blocks may comprises: a first color conversion block disposed in the red subpixel and configured to convert blue light into red light, and a second color conversion block disposed in the green subpixel and configured to convert blue light into green light.

The display device may further comprise a transparent organic layer disposed on the planarization layer in the blue subpixel and/or surrounded by the black bank.

The first color conversion block and the second color conversion block may have different sizes or shapes.

The display device may further comprise an assembling block disposed in the blue subpixel. The assembling block may comprise a plurality of magnetic particles, and a dielectric material configured to surround the plurality of magnetic particles.

The first color conversion block, the second color conversion block, and the assembling block may have different sizes or shape.

The assembling block may further comprise scattering particles.

The plurality of magnetic particles may be dispersed in resin and the dielectric material of the assembling block may be a dielectric film configured to surround the resin.

The assembling block may have a shape or configuration in which the plurality of magnetic particles of the assembling block may be fixed and dispersed in the dielectric material of the assembling block. The dielectric material of the assembling block may be a solid dielectric material.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. All the technical concepts in the equivalent scope of the present disclosure should be construed as falling within the scope of the present disclosure.

## Claims

1. A display device comprising:
a substrate on which a plurality of subpixels is defined;
a plurality of light-emitting elements at least one of which is disposed in a corresponding subpixel of the plurality of subpixels on the substrate; and
a plurality of color conversion blocks disposed on at least one light-emitting element among the plurality of light-emitting elements and configured to convert a wavelength of light emitted from the light-emitting element,
wherein each of the plurality of color conversion blocks comprises:
a plurality of color conversion particles;
a plurality of magnetic particles; and
a dielectric material surrounding the plurality of color conversion particles and the plurality of magnetic particles.

2. The display device of claim 1, wherein each of the plurality of color conversion blocks further comprises resin in which the plurality of color conversion particles and the plurality of magnetic particles are dispersed, and the dielectric material is a dielectric film surrounding the resin, or
wherein each of the plurality of color conversion blocks has a configuration in which the plurality of color conversion particles and the plurality of magnetic particles are fixed and/or dispersed in the dielectric material, the dielectric material being a solid dielectric material.

3. The display device of claim 1 or 2, wherein the plurality of magnetic particles each comprises:
a metal particle; and
a metal layer surrounding the metal particle and having higher reflectance than the metal particle.

4. The display device according to any one of the preceding claims, wherein each of the plurality of color conversion blocks further comprises a plurality of scattering particles.

5. The display device according to any one of the preceding claims, further comprising:
a planarization layer disposed on the plurality of light-emitting elements; and
a plurality of assembling lines provided on the planarization layer and disposed at one side and the other side of at least one light-emitting element among the plurality of light-emitting elements.

6. The display device of claim 5, wherein the plurality of color conversion blocks is disposed on the planarization layer and overlaps the plurality of assembling lines; and/or
wherein a bonding layer is disposed between the planarization layer and the plurality of color conversion blocks.

7. The display device of claim 5 or 6, wherein in a cross-sectional view, the each of the plurality of color conversion blocks has an inversely tapered shape, and a width of a bottom surface of each of the plurality of color conversion blocks is smaller than a width of a top surface of each of the plurality of color conversion blocks.

8. The display device of claim 7, further comprising a black bank covering one end of each of the plurality of assembling lines;
wherein in the cross-sectional view, the black bank has a tapered shape, and the plurality of color conversion blocks each has an inversely tapered shape corresponding to the tapered shape of the black bank.

9. The display device according to any one of the preceding claims, wherein a bottom surface and/or a top surface of each of the plurality of color conversion blocks includes one or more convex surfaces.

10. The display device according to any one of the preceding claims, wherein the plurality of subpixels comprises a red subpixel, a green subpixel, and a blue subpixel,
wherein the plurality of light-emitting elements are blue light-emitting elements configured to emit blue light, and
wherein the plurality of color conversion blocks comprises:
a first color conversion block disposed in the red subpixel and configured to convert blue light into red light; and
a second color conversion block disposed in the green subpixel and configured to convert blue light into green light.

11. The display device of claim 10, further comprising:
a transparent organic layer disposed on the planarization layer in the blue subpixel.

12. The display device of claim 10, wherein the first color conversion block and the second color conversion block have different sizes or shapes.

13. The display device of claim 10, further comprising:
an assembling block disposed in the blue subpixel, the assembling block comprising a plurality of magnetic particles and a dielectric material surrounding the plurality of magnetic particles.

14. The display device of claim 13, wherein the first color conversion block, the second color conversion block, and the assembling block have different sizes or shape; and/or wherein the assembling block further comprises scattering particles.

15. The display device of claim 13 or 14, wherein the plurality of magnetic particles is dispersed in resin and the dielectric material of the assembling block is a dielectric film surrounding the resin; and/or
wherein the assembling block has a configuration in which the plurality of magnetic particles of the assembling block is fixed and dispersed in the dielectric material of the assembling block which is a solid dielectric material.

## Amended claims

### Amended claims in accordance with Rule 137(2) EPC.

1. A display device comprising:
a substrate (110) on which a plurality of subpixels (SP_R; SP_G; SP_B) is defined;
a plurality of light-emitting elements (120) at least one of which is disposed in a corresponding subpixel of the plurality of subpixels on the substrate (110);
a planarization layer (118) disposed on the plurality of light-emitting elements (120);
a plurality of assembling lines (AL1; AL2) provided on the planarization layer (118) and disposed at one side and the other side of at least one light-emitting element (120) among the plurality of light-emitting elements (120); and
a plurality of color conversion blocks (140; 150) each disposed on one light-emitting element (120) among the plurality of light-emitting elements (120) and configured to convert a wavelength of light emitted from the light-emitting element (120),
wherein each of the plurality of color conversion blocks (140; 150) comprises:
a plurality of color conversion particles (141; 151);
a plurality of magnetic particles (MP); and
a dielectric material surrounding the plurality of color conversion particles (141; 151) and the plurality of magnetic particles (MP).

2. The display device of claim 1, wherein each of the plurality of color conversion blocks (140; 150) further comprises resin (RS) in which the plurality of color conversion particles (141; 151) and the plurality of magnetic particles (MP) are dispersed, and the dielectric material is a dielectric film (PF) surrounding the resin (RS), or
wherein each of the plurality of color conversion blocks (140, 150) has a configuration in which the plurality of color conversion particles (141; 151) and the plurality of magnetic particles (MP) are fixed and/or dispersed in the dielectric material, the dielectric material being a solid dielectric material (CP).

3. The display device of claim 1 or 2, wherein the plurality of magnetic particles (MP) each comprises:
a metal particle (MP); and
a metal layer (MP_R) surrounding the metal particle (MP) and having higher reflectance than the metal particle (MP).

4. The display device according to any one of the preceding claims, wherein each of the plurality of color conversion blocks (140; 150) further comprises a plurality of scattering particles (SP).

5. The display device according to any one of the preceding claims, wherein the plurality of color conversion blocks (140; 150) is disposed on the planarization layer (118) and overlaps the plurality of assembling lines (AL1; AL2); and/or
wherein a bonding layer (119) is disposed between the planarization layer (118) and the plurality of color conversion blocks (140; 150).

6. The display device according to any one of the preceding claims, wherein in a cross-sectional view, the each of the plurality of color conversion blocks (140; 150) has an inversely tapered shape, and a width of a bottom surface of each of the plurality of color conversion blocks (140; 150) is smaller than a width of a top surface of each of the plurality of color conversion blocks (140; 150).

7. The display device of claim 6, further comprising a black bank (BB2) covering one end of each of the plurality of assembling lines (AL1; AL2);
wherein in the cross-sectional view, the black bank (BB2) has a tapered shape, and the plurality of color conversion blocks (140; 150) each has an inversely tapered shape corresponding to the tapered shape of the black bank (BB2).

8. The display device according to any one of the preceding claims, wherein a bottom surface and/or a top surface of each of the plurality of color conversion blocks (140; 150) includes one or more convex surfaces.

9. The display device according to any one of the preceding claims, wherein the plurality of subpixels comprises a red subpixel (SP_R), a green subpixel (SP_G), and a blue subpixel (SP_B),
wherein the plurality of light-emitting elements (120) are blue light-emitting elements configured to emit blue light, and
wherein the plurality of color conversion blocks (140; 150) comprises:
a first color conversion block (140) disposed in the red subpixel (SP_R) and configured to convert blue light into red light; and
a second color conversion block (150) disposed in the green subpixel (SP_G) and configured to convert blue light into green light.

10. The display device of claim 9, further comprising:
a transparent organic layer (160) disposed on the planarization layer (118) in the blue subpixel (SP_B).

11. The display device of claim 9, wherein the first color conversion block (140) and the second color conversion block (150) have different sizes or shapes.

12. The display device of claim 9, further comprising:
an assembling block (560) disposed in the blue subpixel (SP_B), the assembling block (560) comprising a plurality of magnetic particles (MP) and a dielectric material surrounding the plurality of magnetic particles (MP).

13. The display device of claim 12, wherein the first color conversion block (140), the second color conversion block (150), and the assembling block (560) have different sizes or shape; and/or
wherein the assembling block (560) further comprises scattering particles (SP).

14. The display device of claim 12 or 13, wherein the plurality of magnetic particles (MP) is dispersed in resin (RS) and the dielectric material of the assembling block (560) is a dielectric film (PF) surrounding the resin (RS); and/or
wherein the assembling block (560) has a configuration in which the plurality of magnetic particles (MP) of the assembling block (560) is fixed and dispersed in the dielectric material of the assembling block (560) which is a solid dielectric material (CP).
